# EUROPÄISCHE PATENTSCHRIFT

(11) **EP 2 870 589 B1**
(45) Veröffentlichungstag und Bekanntmachung des Hinweises auf die Patenterteilung: **09.09.2020**
(21) Anmeldenummer: 13734967.6
(22) Anmeldetag: 04.07.2013
(51) Int. Cl.: G07D 7/04, G07D 7/20

(54) **KALIBRIEREN EINES MAGNETSENSORS**
MAGNET SENSOR CALIBRATION
CALIBRATION D'UN CAPTEUR MAGNÉTIQUE

(30) Priorität: 06.07.2012 DE 102012013516
(43) Veröffentlichungstag der Anmeldung: 13.05.2015
(73) Patentinhaber: Giesecke+Devrient Currency Technology GmbH, 81677 München (DE)
(72) Erfinder: SCHÜTZMANN, Jürgen, 85276 Pfaffenhofen (DE); STEIN, Dieter, 83607 Holzkirchen (DE); PRADEL, Helmut, 80796 München (DE); SACQUARD, David, 81929 München (DE)
(86) Internationale Anmeldenummer: PCT/EP2013/001968
(87) Internationale Veröffentlichungsnummer: WO 2014/005714

(56) Entgegenhaltungen:
- WO-A1-2010/031576
- DE-A1- 19 625 224
- US-A- 5 761 089
- US-A1- 2011 148 408
- US-B1- 6 241 069

## Beschreibung

Die Erfindung betrifft ein Verfahren zum Kalibrieren eines Magnetsensors, der zur Prüfung von Wertdokumenten ausgebildet ist. Außerdem betrifft die Erfindung einen Magnetsensor, der durch das erfindungsgemäße Verfahren kalibrierbar ist und eine Wertdokumentbearbeitungsvorrichtung, die einen solchen Magnetsensor aufweist.

Zur Prüfung von Wertdokumenten werden üblicherweise Sensoren verwendet, mit denen die Art der Wertdokumente bestimmt wird und/oder mit denen die Wertdokumente auf Echtheit und/oder auf ihren Zustand geprüft werden. Derartige Sensoren werden z.B. zur Prüfung von Banknoten, Schecks, Ausweisen, Tickets, Gutscheinen und dergleichen verwendet. Die Wertdokumente werden in einer Vorrichtung zur Wertdokumentbearbeitung geprüft, in der, je nach den zu prüfenden Wertdokumenteigenschaften, einer oder mehrere unterschiedliche Sensoren enthalten sind.

Beispielsweise werden die Wertdokumente mit Hilfe von Magnetsensoren geprüft. Beispielsweise werden in der US2011/0148408 A1 dazu zwei Sensorzeilen verwendet, von denen eine hartmagnetische Magnetbereiche und die andere weichmagnetische Magnetbereiche prüft. Aus der US5761089 A ist es bekannt, für das Magnetsignal unterschiedlicher Wertdokumentarten unterschiedliche Verstärkungsfaktoren zu verwenden, um die unterschiedliche Magnetsignalhöhe auszugleichen, die aus der unterschiedlichen Menge des auf das Wertdokument aufgebrachten Magnetmaterials resultiert. Üblicherweise werden Magnetsensoren in bestimmten zeitlichen Abständen oder bei aktuellem Anlass auf ihre Funktionsfähigkeit überprüft, wie es z.B. aus der WO2010/031576 A1 bekannt ist. Zur Überprüfung eines Magnetsensors wird dieser zunächst kalibriert und anschließend, falls nötig, justiert. Die Kalibrierung erfolgt üblicherweise mit Hilfe von Kalibriermedien, die dem Sensor zugeführt werden und von denen der Magnetsensor Kalibriermesswerte aufnimmt. Die Kalibriermedien können für die Überprüfung einer oder mehrerer Eigenschaften eines einzelnen Sensors ausgebildet sein, oder für die Überprüfung mehrerer oder aller relevanten Eigenschaften von mehreren oder allen relevanten Sensoren der Vorrichtung zur Wertdokumentbearbeitung. Beispielsweise werden für die Kalibrierung von Magnetsensoren Papierblätter mit bekannten, vordefinierten Eigenschaften als Kalibriermedien eingesetzt.

Zur Wertdokumentprüfung werden die zu prüfenden Wertdokumente an dem Magnetsensor vorbeitransportiert, der dabei Magnetsignale des jeweiligen Wertdokuments detektiert. Um den Magnetsensor zu kalibrieren wird, an Stelle der Wertdokumente, ein Kalibriermedium an dem Magnetsensor vorbeitransportiert, wobei der Magnetsensor Kalibriermesswerte des Kalibriermediums detektiert. Die Kalibriermesswerte werden mit Sollwerten verglichen, die dem Kalibriermedium zugeordnet sind. Falls die Kalibriermesswerte des Kalibriermediums von den Sollwerten des Kalibriermediums abweichen, wird gegebenenfalls eine Justage des betreffenden Magnetsensors durchgeführt, bei der der Sensor möglichst so eingestellt wird, dass er beim Detektieren des Kalibriermediums zumindest näherungsweise die Sollwerte liefert. Der so justierte Sensor wird anschließend zur Prüfung von Wertdokumenten verwendet. Nachteilig ist bei dem bisherigen Verfahren, dass nach dem Kalibrieren eines Magnetsensors - trotz des anschließenden Justierens des Magnetsensors - das von dem Magnetsensor detektierte Magnetsignal eines Wertdokuments dennoch mit Messabweichungen behaftet sein kann.

Eine Aufgabe der vorliegenden Erfindung ist es, Messabweichungen eines Magnetsensors, die trotz der Kalibrierung und Justage des Magnetsensors verbleiben, zu beheben.

Diese Aufgabe wird durch die Gegenstände der unabhängigen Ansprüche gelöst. In davon abhängigen Ansprüchen sind vorteilhafte Weiterbildungen und Ausgestaltungen der Erfindung angegeben.

Die Erfindung beruht auf der Erkenntnis, dass - trotz des Kalibrierens und Justierens des Magnetsensors - Messabweichungen verbleiben, die durch den Magnetsensor selbst zustande kommen. Es wurde gefunden, dass die Fehler z.B. auf Schwankungen bei der mechanischen Befestigung von magnetosensitiven Elementen des Magnetsensors beruhen oder von Magneten des Magnetsensors, die zur Magnetisierung der Wertdokumente verwendet werden. Außerdem wurde erkannt, dass durch das Kalibrieren und Justieren nur bestimmte Fehler korrigiert werden, wie z.B. Einbauschwankungen der magnetosensitiven Elemente des Magnetsensors, andere Fehler dabei aber nicht berücksichtigt werden und dass diese anderen Fehler das detektierte Magnetsignal weiterhin verfälschen können.

Untersuchungen haben gezeigt, dass sich manche Fehler des Magnetsensors in Abhängigkeit davon, welches Magnetmaterial der Magnetsensor detektiert, unterschiedlich auf das detektierte Magnetsignal auswirken. Bei Magnetmaterial, dessen Magnetisierung stark von dem angelegten Magnetfeld abhängt, wie z.B. bei weichmagnetischem Magnetmaterial, wirkt sich eine Schwankung des angelegten Magnetfelds deutlich auf das detektierte Magnetsignal aus. Bei einem anderen Magnetmaterial, dessen Magnetisierung kaum von dem angelegten Magnetfeld abhängt, wie z.B. bei hartmagnetischem Magnetmaterial, wirkt sich dagegen eine Schwankung des angelegten Magnetfelds kaum auf das detektierte Magnetsignal aus. Bei bisherigen Magnetsensoren, die nur eine Art von Kalibrierparametern verwenden, führt dies zu Messabweichungen. Denn, wenn ein solcher Magnetsensor mit Hilfe eines Kalibriermediums mit hartmagnetischem Magnetmaterial kalibriert wird, dessen Magnetisierung tolerant gegenüber Schwankungen des angelegten Magnetfelds ist, dann werden Fehler, die das zum Magnetisieren des Wertdokuments angelegte Magnetfeld betreffen, beim anschließenden Justieren des Magnetsensors nicht berücksichtigt. Bei einer anschließenden Detektion von weichmagnetischem Magnetmaterial verfälschen diese Fehler jedoch die detektierten Magnetsignale. Wird ein solcher Magnetsensor hingegen auf die Kalibriermesswerte eines weichmagnetischen Magnetmaterials hin justiert, so werden die Magnetsignale eines Wertdokuments nachträglich zu einem resultierenden Magnetsignal korrigiert, bei dem die Magnetfeldschwankungen berücksichtigt wurden. Beim Detektieren von hartmagnetischem Magnetmaterial eines Wertdokuments wäre dieselbe nachträgliche Korrektur des detektierten Magnetsignals jedoch überflüssig und würde das resultierende Magnetsignal sogar verfälschen.

Im Gegensatz zu den bisherigen Magnetsensoren, die nur eine Art von Kalibrierparametern verwenden, sind bei dem erfindungsgemäßen Magnetsensor für Magnetbereiche aus unterschiedlichem Magnetmaterial unterschiedliche Kalibrierparameter vorgesehen. Der Magnetsensor weist mindestens einen ersten Kalibrierparameter und mindestens einen von dem/den ersten Kalibrierparameter/n unabhängigen zweiten Kalibrierparameter auf und ist wahlweise mit dem/den ersten oder mit dem/den zweiten Kalibrierparameter/n konfigurierbar. Der erste Kalibrierparameter ist dazu vorgesehen ist, ein Magnetsignal des Magnetsensors zu berichtigen, das der Magnetsensor, beim Prüfen eines Wertdokuments, von einem weichmagnetischen Magnetbereich des zu prüfenden Wertdokuments detektiert, um Messabweichungen des Magnetsensors auszugleichen, mit welchen die Magnetsignale, die der Magnetsensor von dem weichmagnetischen Magnetbereich des Wertdokuments detektiert, behaftet sind. Der zweite Kalibrierparameter ist dazu vorgesehen ist, ein Magnetsignal des Magnetsensors zu berichtigen, das der Magnetsensor, beim Prüfen eines Wertdokuments, von einem hartmagnetischen Magnetbereich eines zu prüfenden Wertdokuments detektiert, um Messabweichungen des Magnetsensors auszugleichen, mit welchen die Magnetsignale, die der Magnetsensor von dem hartmagnetischen Magnetbereich des Wertdokuments detektiert, behaftet sind. Zusätzlich kann der Magnetsensor auch noch weitere Kalibrierparameter für andersartige Magnetbereiche des Wertdokuments aufweisen.

Der erfindungsgemäße Magnetsensor ist dazu eingerichtet ist, ein und dasselbe Magnetsignal des Magnetsensors, das dieser von einem zu prüfenden Wertdokument detektiert, entweder mit dem/den ersten Kalibrierparameter/n oder mit dem/den der zweiten Kalibrierparametern zu berichtigen. Damit kann der Magnetsensor zur Detektion unterschiedlicher Magnetmaterialien konfiguriert werden und, je nach Bedarf, die für das zu detektierende Magnetmaterial richtigen Kalibrierparameter verwenden. So lassen sich die oben erwähnten Fehler des Magnetsensors ausgleichen, ohne etwa Änderungen an den Permanentmagneten des Magnetsensors durchführen zu müssen. Durch den ersten und zweiten Kalibrierparameter können also Messwertabweichungen, die der jeweilige Magnetsensor aufweist, für den jeweiligen Magnetsensor individuell ausgeglichen werden.

Der Magnetsensor ist zum Prüfen von Wertdokumenten ausgebildet, die zu deren Prüfung entlang einer Transportrichtung an dem Magnetsensor vorbeitransportiert werden. Zum Kalibrieren des Magnetsensors kann ein Kalibriermedium entlang der Transportrichtung an dem Sensor vorbeitransportiert werden. Beim Kalibrieren des Magnetsensors und beim Prüfen der Wertdokumente werden jeweils Magnetsignale des vorbeitransportierten Kalibriermediums bzw. des Wertdokuments detektiert. Zum Kalibrieren des Magnetsensors und zum Prüfen der Wertdokumente sind verschiedene Betriebsmodi des Magnetsensors vorgesehen, die von außen eingestellt werden können und in denen die aufgenommenen Magnetsignale verschieden verwendet werden. Im Kalibriermodus des Magnetsensors wird der Magnetsensor kalibriert, wobei anhand der von dem Kalibriermedium detektierten Magnetsignale die Funktion des Magnetsensors überprüft wird, und im Anschluss an die Kalibrierung ggf. justiert. Der Magnetsensor kann dazu mit einer Kalibriereinrichtung ausgestattet oder verbunden sein, die eine Kalibriersoftware aufweist, um das Kalibrieren und ggf. Justieren des Magnetsensors durchzuführen. Im Prüfmodus des Magnetsensors werden die Magnetsignale eines Wertdokuments detektiert und zur Bestimmung der Echtheit und/oder der Art und/oder des Zustands des Wertdokuments verwendet.

Der Magnetsensor ist sowohl zum Detektieren von Magnetsignalen hartmagnetischer Magnetbereiche als auch zum Detektieren von Magnetsignalen weichmagnetischer Magnetbereiche ausgebildet. Zu diesem Zweck wird das Wertdokument bzw. das Kalibriermedium, während der Detektion durch den Magnetsensor, einem Magnetfeld ausgesetzt, das durch einen Magneten bereitgestellt wird. Der Magnet kann Teil des Magnetsensors selbst sein oder ein außerhalb des Magnetsensors vorhandener Magnet sein.

In einem Ausführungsbeispiel weist der Magnetsensor mehrere Messspuren auf, durch die der Magnetsensor an mehreren Positionen des Wertdokuments ein Magnetsignal detektieren kann. Pro Messspur weist der Magnetsensor sowohl einen ersten Kalibrierparameter als auch einen zweiten Kalibrierparameter auf, der von dem ersten Kalibrierparameter der jeweiligen Messspur unabhängig ist. Zum Beispiel wird beim Kalibrieren für jede der Messspuren individuell jeweils ein erster und ein zweiter Kalibriermesswert detektiert und auf Basis des für die jeweilige Messspur detektierten ersten/ zweiten Kalibriermesswerts ein erster/ zweiter Kalibrierparameter bestimmt, durch den die jeweilige Messspur konfigurierbar ist.

Insbesondere ist der Magnetsensor dazu eingerichtet, das detektierte Magnetsignal in Abhängigkeit der Position auf dem Wertdokument zu berichtigen, an der der Magnetsensor das Magnetsignal detektiert. Zum Beispiel werden an verschiedenen Positionen des Wertdokuments unterschiedliche Kalibrierparameter verwendet. Alternativ oder zusätzlich kann der Magnetsensor das detektierte Magnetsignal auch in Abhängigkeit der Wertdokumentart des zu prüfenden Wertdokuments, wahlweise mit dem ersten oder mit dem zweiten Kalibrierparameter berichtigen. Zum Beispiel kann der Magnetsensor selbst die Wertdokumentart bestimmen oder die Information über die Wertdokumentart von außen zugeführt bekommen.

Der Magnetsensor weist einen Datenspeicher auf, in dem der mindestens eine erste Kalibrierparameter und der mindestens eine zweite Kalibrierparameter des Magnetsensors hinterlegt sind. Der Datenspeicher kann innerhalb oder außerhalb des Magnetsensors angeordnet sein. In dem Datenspeicher sind verschiedene Kalibrierparameter in Abhängigkeit der Wertdokumentart und/ oder in Abhängigkeit der Position auf dem jeweiligen Wertdokument hinterlegt. In dem Datenspeicher sind Informationen gespeichert, die bestimmen, welche der Magnetsignale, die der Magnetsensor von einem Wertdokument detektiert, mit dem ersten Kalibrierparameter und welche mit dem zweiten Kalibrierparameter zu berichtigen sind. Diese Informationen liegen in dem Datenspeicher insbesondere in Abhängigkeit der Wertdokumentart vor, im Fall von Banknoten z.B. in Abhängigkeit der Währung oder der Denomination oder der Emission der Banknote.

In einem Ausführungsbeispiel weist der Magnetsensor eine Auswerteeinrichtung auf, die eine Auswertesoftware zur Verarbeitung und Auswertung der detektierten Magnetsignale des Magnetsensors aufweist. Die Auswertesoftware ist dazu ausgebildet, im Prüfmodus des Magnetsensors in Abhängigkeit davon, ob das Magnetsignal von einem weichmagnetischen Magnetbereich eines Wertdokuments oder von einem hartmagnetischen Magnetbereich eines Wertdokuments detektiert wird, das jeweilige Magnetsignal entweder auf Basis des ersten oder auf Basis des zweiten Kalibrierparameters zu berichtigen. In Abhängigkeit davon, ob das Magnetsignal von einem weichmagnetischen Magnetbereich oder von einem hartmagnetischen Magnetbereich detektiert wird, kann die Auswertesoftware den ersten oder den zweiten Kalibrierparameter aus der Datenspeicher auslesen und zum Berichtigen des detektierten Magnetsignals verwenden. Die Auswerteeinrichtung ist innerhalb oder außerhalb des Magnetsensors angeordnet. Der für die Kalibrierparameter verwendete Datenspeicher kann Teil der Auswerteeinrichtung des Magnetsensors sein oder mit dieser verbunden sein.

Die Auswertesoftware ist dazu ausgebildet, bei der Prüfung eines Wertdokuments, das Magnetsignal, das der Magnetsensor von einem weichmagnetischen Magnetbereich des zu prüfenden Wertdokuments detektiert, mit dem ersten Kalibrierparameter zu einem resultierenden Magnetsignal zu verrechnen, um Messabweichungen des Magnetsensors auszugleichen, mit welchen die Magnetsignale, die der Magnetsensor von dem weichmagnetischen Magnetbereich des Wertdokuments detektiert, behaftet sind. Und die Auswertesoftware ist dazu ausgebildet, bei der Prüfung eines Wertdokuments das Magnetsignal, das der Magnetsensor von einem hartmagnetischen Magnetbereich des Wertdokuments detektiert, mit dem zweiten Kalibrierparameter zu einem resultierenden Magnetsignal zu verrechnen, um Messabweichungen des Magnetsensors auszugleichen, mit welchen die Magnetsignale, die der Magnetsensor von dem hartmagnetischen Magnetbereich des Wertdokuments detektiert, behaftet sind. Der erste/ zweite Kalibrierparameter ist z.B. ein Faktor, der dazu vorgesehen ist, mit dem detektierten Magnetsignal multipliziert zu werden, das der Magnetsensor von einem weich/ hartmagnetischen Magnetbereich des Wertdokuments detektiert.

Alternativ kann der Magnetsensor auch einen konfigurierbaren elektronischen Verstärker zum Verstärken der detektierten Magnetsignale aufweisen. Im Prüfmodus des Magnetsensors kann dann in Abhängigkeit davon, ob das Magnetsignal von einem weichmagnetischen Magnetbereich eines Wertdokuments oder von einem hartmagnetischen Magnetbereich eines Wertdokuments detektiert wird, die Höhe der Verstärkung entweder auf Basis des ersten oder auf Basis des zweiten Kalibrierparameters eingestellt werden. Wenn das detektierte Magnetsignal von einem weichmagnetischen Magnetbereich eines Wertdokuments detektiert wird, wird die Verstärkung auf Basis des ersten Kalibrierparameters eingestellt und, wenn das detektierte Magnetsignal von einem hartmagnetischen Magnetbereich eines Wertdokuments detektiert wird, die Verstärkung auf Basis des zweiten Kalibrierparameters eingestellt. Bei einem mehrspurigen Magnetsensor kann die Höhe der Verstärkung für jede der Messspuren individuell auf Basis des jeweiligen ersten/ zweiten Kalibrierparameters eingestellt werden.

Alternativ kann der Magnetsensor mindestens ein konfigurierbares magnetosensitives Element aufweisen, dessen Empfindlichkeit konfigurierbar ist. Im Prüfmodus des Magnetsensors kann die Empfindlichkeit in Abhängigkeit davon, ob das Magnetsignal von einem weichmagnetischen Magnetbereich eines Wertdokuments oder von einem hartmagnetischen Magnetbereich eines Wertdokuments detektiert wird, entweder auf Basis des ersten oder auf Basis des zweiten Kalibrierparameters eingestellt werden. Zu diesem Zweck kann z.B. der Messstrom durch das jeweilige magnetosensitive Element des Magnetsensors verändert werden, oder auch eine an das jeweilige magnetosensitive Element angelegte elektrische Spannung, um die Empfindlichkeit des jeweiligen magnetosensitiven Elements gezielt anzupassen.

Zum Kalibrieren des Magnetsensors wird die Funktion des Magnetsensors in einem Kalibriermodus des Magnetsensors überprüft. In dem Kalibriermodus wird ein Kalibriermedium, das beispielsweise mindestens einen weichmagnetischen Magnetbereich und/ oder mindestens einen hartmagnetischen Magnetbereich aufweist, an dem Magnetsensor entlang der Transportrichtung vorbeitransportiert. Während das Kalibriermedium an dem Magnetsensor vorbeitransportiert wird, detektiert der Magnetsensor mindestens einen ersten Kalibriermesswert von dem weichmagnetischen Magnetbereich des Kalibriermediums und/oder mindestens einen zweiten Kalibriermesswert von dem hartmagnetischen Magnetbereich des Kalibriermediums. Der weichmagnetische Magnetbereich und der hartmagnetische Magnetbereich sind jeweils in/auf einem Kalibriermedium enthalten, das zum Kalibrieren des Magnetsensors entlang einer Transportrichtung an dem Magnetsensor vorbeitransportiert wird. Es kann ein Kalibriermedium verwendet werden, das sowohl weich- als auch hartmagnetische Magnetbereiche aufweist. Alternativ können die weichmagnetischen und hartmagnetischen Magnetbereiche aber auch auf unterschiedlichen Kalibriermedien vorhanden sein, die zum Kalibrieren getrennt voneinander an dem Magnetsensor vorbeitransportiert werden und von dem Magnetsensor detektiert werden.

Das Kalibrieren des Magnetsensors wird z.B. innerhalb einer Vorrichtung zur Wertdokumentbearbeitung durchgeführt werden, in die der Magnetsensor eingebaut ist. Zum Vorbeitransportieren des Kalibriermediums dient dann das Transportsystem der Vorrichtung, das die Wertdokumente transportiert. Das Kalibrieren des Magnetsensors kann aber auch außerhalb der Vorrichtung zur Wertdokumentbearbeitung durchgeführt werden, z.B. an einem Kalibrierplatz. In diesem Fall wird das Vorbeitransportieren des Kalibriermediums durch andere Transportmittel, z.B. durch eine rotierbare zylinderförmige Transporttrommel erreicht, auf der ein Kalibriermedium mit weichmagnetischem und/ oder hartmagnetischem Magnetmaterial vorhanden ist. Durch Rotation der Transporttrommel um ihre Achse wird das jeweilige Magnetmaterial an dem ortsfest installierten Magnetsensor periodisch vorbeitransportiert, wobei der Magnetsensor entsprechende Kalibriermesswerte detektiert.

Nach deren Detektion werden der detektierte erste und/oder zweite Kalibriermesswert weiterverarbeitet, um die Funktion des Magnetsensors anhand des detektierten ersten und/oder zweiten Kalibriermesswerts zu überprüfen. Beim Weitererarbeiten der Kalibriermesswerte überprüft der Magnetsensor die Kalibriermesswerte z.B. auf Messabweichungen im Vergleich zu Sollwerten und führt, in Abhängigkeit des Ergebnisses der Überprüfung, ggf. eine Justage des Magnetsensors durch. Die Kalibriermesswerte werden mit Sollwerten verglichen, die dem Kalibriermedium zugeordnet sind. Die Sollwerte können über eine entsprechende Schnittstelle in den Magnetsensor oder in die Vorrichtung zur Wertdokumentbearbeitung eingebracht werden. Die Sollwerte können durch manuelle Eingabe, über eine Netzwerkverbindung oder über einen Datenträger eingebracht werden oder durch Identifizierung des Kalibriermediums mit Hilfe des Magnetsensors oder mit Hilfe eines anderen Sensors der Vorrichtung und automatischer Auswahl der zugehörigen Sollwerte in Abhängigkeit der Identität des Kalibriermediums. Die Sollwerte können feste Zahlenwerte sein, z.B. mehrere Zahlenwerte für verschiedene Abschnitte des Wertdokuments. Die Zahlenwerte können mit Schwankungsbreiten versehen sein, durch die akzeptable Abweichungen von den Sollwerten erlaubt werden.

Falls die Kalibriermesswerte von den Sollwerten des Kalibriermediums abweichen, kann nach dem Kalibrieren eine Justage des Sensors erfolgen. Das Justieren des Sensors kann automatisch erfolgen oder erst nach einer entsprechenden Bestätigung von außen manuell ausgelöst werden, z.B. durch eine Bedienperson, die die Kalibrierung des Sensors veranlasst hat und der das Ergebnis der Kalibrierung mitgeteilt wird. Falls die Abweichung in dem Akzeptanzbereich um den Sollwert liegt, kann auch auf die Justage des Magnetsensors verzichtet werden. Die Justage des Magnetsensors kann aber auch vorsorglich durchgeführt werden, unabhängig davon, ob die detektierten Kalibriermesswerte von den Sollwerten abweichen oder nicht.

Die optionale Justage des Magnetsensors wird auf Basis der detektierten ersten Kalibriermesswerte und/ oder auf Basis der detektierten zweiten Kalibriermesswerte durchgeführt. Bei der Justage des Magnetsensors wird der erste Kalibrierparameter anhand des detektierten ersten Kalibriermesswerts und/ oder der zweite Kalibrierparameter anhand des detektierten zweiten Kalibriermesswerts ermittelt und dadurch die Konfiguration des Magnetsensors mit dem ersten und/oder mit dem zweiten Kalibrierparameter verändert. So werden die Kalibrierparameter angepasst, die der Magnetsensor zur Verarbeitung von Magnetsignalen der Wertdokumente verwendet. Zur Justage des Magnetsensors können neue, durch die Kalibrierung bestimmte Kalibrierparameter in dem Datenspeicher abgespeichert werden. Zur Justage kann aber auch die Höhe der Verstärkung des Magnetsignal-Verstärkers in Abhängigkeit des Kalibierparameters angepasst werden oder die Empfindlichkeit des magnetosensitiven Elements des Magnetsensors in Abhängigkeit des Kalibierparameters angepasst werden. Optional kann auch eine Hardware-Justage des Magnetsensors durchgeführt werden, z.B. bei sehr großen Abweichungen der Kalibriermesswerte von den Sollwerten.

Zum Überprüfen der Funktion des Magnetsensors wird z.B. der Unterschied zwischen den detektierten ersten/ zweiten Kalibriermesswerten und den ersten/ zweiten Sollwerten ermittelt und überprüft, ob die detektierten ersten/ zweiten Kalibriermesswerte innerhalb eines Akzeptanzbereichs um den erste/ zweiten Sollwert liegen. Die Justage des Magnetsensors wird nur dann durchgeführt, falls der detektierte erste/zweite Kalibriermesswert außerhalb eines Akzeptanzbereichs um den ersten/ zweiten Sollwert liegt.

Um den Magnetsensor für eine Prüfung weichmagnetischer Magnetbereiche zu kalibrieren werden erste Kalibriermesswerte eines Kalibriermediums (z.B. eines weichmagnetischen Magnetbereichs des Kalibriermediums) detektiert und überprüft, ob diese ersten Kalibriermesswerte ersten Sollwerten entsprechen, die für das Kalibriermedium vorgegeben sind. In Abhängigkeit des Ergebnisses der Überprüfung der detektierten ersten Kalibriermesswerte wird eine Justage des Magnetsensors auf Basis der ersten Kalibriermesswerte durchgeführt, bei der anhand der von dem Magnetsensor detektierten ersten Kalibriermesswerte der jeweilige erste Kalibrierparameter angepasst wird.

Um den Magnetsensor für eine Prüfung hartmagnetischer Magnetbereiche zu kalibrieren werden zweite Kalibriermesswerte eines Kalibriermediums (z.B. eines hartmagnetischen Magnetbereichs des Kalibriermediums) detektiert und überprüft, ob diese zweiten Kalibriermesswerte zweiten Sollwerten entsprechen, die für das Kalibriermedium vorgegeben sind. In Abhängigkeit des Ergebnisses der Überprüfung der detektierten zweiten Kalibriermesswerte wird eine Justage des Magnetsensors auf Basis der zweiten Kalibriermesswerte durchgeführt, bei der anhand der von dem Magnetsensor detektierten zweiten Kalibriermesswerte der jeweilige zweite Kalibrierparameter angepasst wird.

Beim Überprüfen, ob die von dem Magnetsensor detektierten ersten/ zweiten Kalibriermesswerte des weich-/ hartmagnetischen Magnetbereichs den ersten/zweiten Sollwerten entsprechen, wird z.B. überprüft, ob diese in einem ersten/zweiten Akzeptanzbereich um den jeweiligen Sollwert liegen, der für den weich-/hartmagnetischen Magnetbereich des Kalibriermediums vorgegeben ist und der den jeweiligen Sollwert einschließt. Falls die Überprüfung ergibt, dass die detektierten Kalibriermesswerte des weich-/ hartmagnetischen Magnetbereichs den ersten/ zweiten Sollwerten entsprechen, bleibt der erste/ zweite Kalibrierparameter unverändert bei seinem Ausgangswert. Falls die Überprüfung ergibt, dass die detektierten ersten/ zweiten Kalibriermesswerte des weich/hartmagnetischen Magnetbereichs den ersten/ zweiten Sollwerten nicht entsprechen, wird der erste/zweite Kalibrierparameter auf Basis des detektierten ersten/zweiten Kalibriermesswerts neu ermittelt. Der neu ermittelte erste/zweite Kalibrierparameter ist dazu vorgesehen, mit den von einem weich-/hartmagnetischen Magnetbereich eines zu prüfenden Wertdokuments detektierten Magnetsignalen verrechnet zu werden, um Messabweichungen auszugleichen, mit denen die Magnetsignale, die von dem weich-/hartmagnetischen Magnetbereich des Wertdokuments detektiert werden, behaftet sind.

Nach dem Überprüfen der Funktion des Magnetsensors, und ggf. nach einer Justage des Magnetsensors, wird der Magnetsensor zur Prüfung eines Wertdokuments verwendet, das mindestens einen weichmagnetischen Magnetbereich und/ oder mindestens einen hartmagnetischen Magnetbereich aufweist. Zum Prüfen des Wertdokuments wird das Wertdokument an dem Magnetsensor entlang der Transportrichtung vorbeitransportiert, wobei der Magnetsensor von dem weichmagnetischen Magnetbereich des Wertdokuments Magnetsignale detektiert und / oder wobei der Magnetsensor von dem hartmagnetischen Magnetbereich des Wertdokuments Magnetsignale detektiert. Die von dem weichmagnetischen Magnetbereich detektierten Magnetsignale werden mit Hilfe des ersten Kalibrierparameters berichtigt, um Messabweichungen des Magnetsensors auszugleichen, mit welchen die Magnetsignale, die der Magnetsensor von dem weichmagnetischen Magnetbereich des Wertdokuments detektiert, behaftet sind. Alternativ oder zusätzlich werden die von dem hartmagnetischen Magnetbereich detektierten Magnetsignale mit Hilfe des zweiten Kalibrierparameters berichtigt, um Messabweichungen des Magnetsensors auszugleichen, mit welchen die Magnetsignale, die der Magnetsensor von dem hartmagnetischen Magnetbereich des Wertdokuments detektiert, behaftet sind. Das berichtigte Magnetsignal des weichmagnetischen Magnetbereichs und/ oder des hartmagnetischen Magnetbereichs wird zum Prüfen von magnetischen Eigenschaften des Wertdokuments verwendet.

Die Erfindung betrifft auch eine Vorrichtung zur Bearbeitung von Wertdokumenten, die einen erfindungsgemäßen Magnetsensor aufweist. Die Wertdokumente werden durch den Magnetsensor z.B. in einer Vorrichtung zur Wertdokumentbearbeitung geprüft, die ein Transportsystem zum Vorbeitransportieren der Wertdokumente an dem Sensor entlang einer Transportrichtung aufweist. Die Vorrichtung kann eine Auswerteeinrichtung zum Auswerten der detektierten Magnetsignale und ggf. zum Kalibrieren des Magnetsensors aufweisen. Die Vorrichtung zur Wertdokumentbearbeitung kann auch mit einer Kalibriereinrichtung ausgestattet sein, die dazu ausgebildet ist, den Magnetsensor nach dem erfindungsgemäßen Verfahren zu kalibrieren und gegebenenfalls zu justieren. Die Vorrichtung weist z.B. einen Kalibriermodus auf, in dem einer oder mehrere Sensoren der Vorrichtung kalibriert werden können. Die Vorrichtung kann außerdem mit Ein- und Ausgabefächern zum Zuführen bzw. Abführen der Wertdokumente in die bzw. aus der Vorrichtung ausgestattet sein.

Zur Kalibrierung des Magnetsensors wird bevorzugt ein Satz von Kalibriermedien verwendet, z.B. ein Päckchen von Kalibriermedien, die einzeln nacheinander durch den Magnetsensor detektiert werden. Durch die Kalibrierung mit einer Vielzahl von Kalibriermedien kann die Genauigkeit der Kalibrierung erhöht werden. Zum Kalibrieren werden die einzelnen Kalibriermedien des Satzes nacheinander durch die Vorrichtung und an dem zu kalibrierenden Magnetsensor vorbeitransportiert. Beispielsweise unterscheiden sich die Kalibriermedien des Satzes nur in ihrer Kennung, während deren Magnetbereiche gleich sind. Für jedes einzelne Kalibriermedium des Satzes werden Kalibriermesswerte bestimmt. Aus den einzelnen ersten bzw. zweiten Kalibriermesswerten der Kalibriermedien des Satzes wird z.B. ein erster bzw. zweiter Mittelwert gebildet und überprüft, ob der erste/ zweite Mittelwerts einem ersten/ zweiten Sollwert entspricht, der für den Satz an Kalibriermedien erwartet wird. Optional folgt wie oben beschrieben ein Justieren des Magnetsensors, falls der erste Mittelwert und/oder zweite Mittelwert dem jeweiligen Sollwert nicht entspricht.

Nachfolgend wird die Erfindung beispielhaft anhand der folgenden Figuren erläutert.

Es zeigen:
- Figur 1a: Ein Kalibriermedium, das zum Kalibrieren eines Magnetsensors an dem Magnetsensor vorbeitransportiert wird,
- Figur 1b: ein Wertdokument, das zu dessen Prüfung an dem Magnetsensor vorbeitransportiert wird,
- Figur 2a-c: Magnetisierungskurven (Fig. 2a) und Kalibriermesswerte (Fig. 2b) für verschiedene Magnetmaterialien, die Messabweichungen des Magnetsensors zeigen und daraus ermittelte Kalibrierparameter (Fig. 2c),
- Figur 3a-b: Magnetsignal eines weichmagnetischen Magnetbereichs des Wertdokuments und dessen Berichtigung mit Hilfe der zugehörigen Kalibrierparameter,
- Figur 3c-d: Magnetsignal eines hartmagnetischen Magnetbereichs des Wertdokuments und dessen Berichtigung mit Hilfe der zugehörigen Kalibrierparameter.

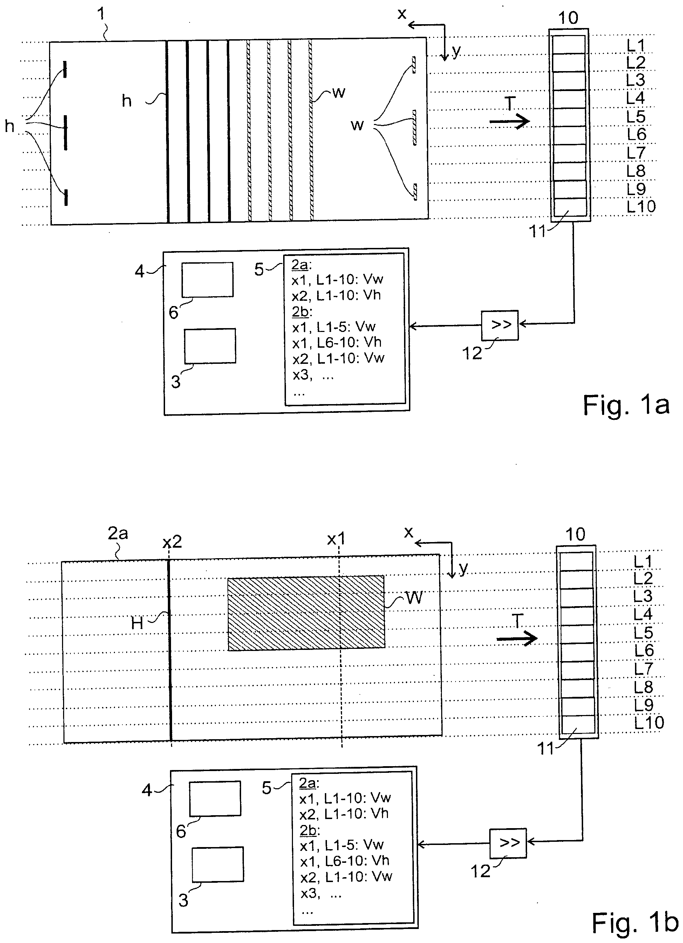

Die Figuren 1a und 1b zeigen einen Magnetsensor 10, der zehn Messspuren L1-L10 aufweist, die senkrecht zur Transportrichtung T des Kalibriermediums 1 angeordnet sind. Für jede Messspur L1-L10 ist jeweils ein magnetosensitives Element 11 vorgesehen, das Magnetsignale eines an dem Magnetsensor 10 vorbeitransportierten Kalibriermediums 1, vgl. Figur 1a, bzw. eines vorbeitransportierten Wertdokuments 2a detektiert, vgl. Figur 1b. Um sowohl hartmagnetische als auch weichmagnetische Magnetbereiche detektieren zu können, weist der Magnetsensor z.B. Permanentmagnete auf (nicht gezeigt), die das Magnetmaterial des zu detektierende Kalibriermediums 1 bzw. des Wertdokuments 2a magnetisieren, so dass sich dieses während der Detektion der Magnetsignale in einem äußeren Magnetfeld befindet. Die magnetosensitiven Elemente 11 sind z.B. induktive oder magnetoresistive Elemente (z.B. GMR-, AMR-Elemente oder konventionelle magnetoresistive Elemente) oder Hallelemente. Zu einem Zeitpunkt vor der Kalibrierung des Magnetsensors 10 wurden für jede Messspur L1-L10 die jeweiligen Kalibrierparameter Vw, Vh auf einen bestimmten Ausgangswert festgelegt, z.B. bei einer früheren Kalibrierung oder bei der Herstellung des Magnetsensors.

Das von den magnetosensitiven Elementen 11 detektierte Magnetsignal wird durch einen Verstärker 12 verstärkt. Optional ist jeder Messspur ein eigener Verstärker zugeordnet. Die verstärkten Magnetsignale der Messspuren L1-L10 werden zu einer Auswerteeinrichtung 4 geleitet, die die von einem Wertdokument 2a detektierten Magnetsignale mit Hilfe einer Auswertesoftware 6 auswertet, die die Auswerteeinrichtung 4 im Prüfmodus des Magnetsensors ausführt. Außer dem Prüfmodus hat der Magnetsensor auch einen Kalibriermodus, in dem eine Kalibrierung und ggf. Justage des Magnetsensors 10 mit Hilfe der von dem Kalibriermedium detektierten Kalibriermesswerte durchgeführt werden kann. Dazu wird eine Kalibrier- und Justagesoftware 3 verwendet, die ebenfalls von der Auswerteeinrichtung 4 ausgeführt wird. Der Verstärker 12 und die Auswerteinrichtung 4 können in einem Gehäuse des Magnetsensors 10 angeordnet sein oder außerhalb, z.B. in der Vorrichtung zur Wertdokumentbearbeitung. Die in den Figuren 1a und 1b gezeigte Anordnung kann Teil einer Vorrichtung zur Wertdokumentbearbeitung sein, in der Wertdokumente mit Hilfe des Magnetsensors 10 geprüft werden. Alternativ kann auch eine externe Kalibriereinrichtung verwendet werden, die zur Kalibrierung an den Magnetsensor oder an die Vorrichtung angeschlossen wird.

Das in Figur 1a gezeigte Kalibriermedium 1 wird zum Kalibrieren des Magnetsensors 10 verwendet und zu diesem Zweck entlang einer Transportrichtung T an dem Magnetsensor 10 vorbeitransportiert. Der Magnetsensor 10 detektiert dabei Magnetsignale des Kalibriermediums 1, die im Folgenden als Kalibriermesswerte bezeichnet werden. Das Kalibriermedium 1 weist im vorliegenden Ausführungsbeispiel vier linienförmige Magnetbereiche h aus hartmagnetischem Magnetmaterial und vier linienförmige Magnetbereiche w aus weichmagnetischem Magnetmaterial auf. Von diesen Magnetbereichen h, w detektiert der Magnetsensor 10 im Idealfall, sofern er optimal justiert ist, bestimmte Sollwerte. In diesem Ausführungsbeispiel sind am Anfang des Kalibriermediums 1 zusätzlich drei Markierungen aus weichmagnetischem Magnetmaterial und am Ende des Kalibriermediums 1 drei Markierungen aus hartmagnetischem Magnetmaterial aufgebracht, die jeweils entlang einer Linie senkrecht zur Transportrichtung T angeordnet sind. Die Markierungen liefern Magnetsignale, mit deren Hilfe beim Kalibrieren des Magnetsensors 10 auch die Transportlage des Kalibriermediums 1 mit erfasst werden kann. Bei nicht-idealer Transportlage, z.B. bei Schräglauf des Kalibriermediums 1, oder bei abweichender Transportgeschwindigkeit, können die detektierten Kalibriermesswerte dann entsprechend korrigiert werden.

In Figur 1b ist ein Wertdokument 2a dargestellt, das zu dessen Prüfung entlang einer Transportrichtung T an dem Magnetsensor 10 vorbeitransportiert wird. Der Magnetsensor 10 detektiert dabei Magnetsignale des Wertdokuments 2a. Jede Messspur L1-L10 detektiert zeitlich nacheinander Magnetsignale des jeweils in ihren Erfassungsbereich liegenden Abschnitts des Wertdokuments, um eine ortsaufgelöste Detektion in x- und y-Richtung durchzuführen. Das Wertdokument wird dadurch quasi zweidimensional abgescannt, um dessen magnetische Eigenschaften zu prüfen. Das Wertdokument 2a weist beispielhaft sowohl einen weichmagnetischen Magnetbereich W als auch einen hartmagnetischen Magnetbereich H auf, wobei es sich um dasselbe oder um ein anderes (bevorzugt aber ähnliches) hart-/weichmagnetisches Magnetmaterial handelt wie bei dem Kalibriermedium 1.

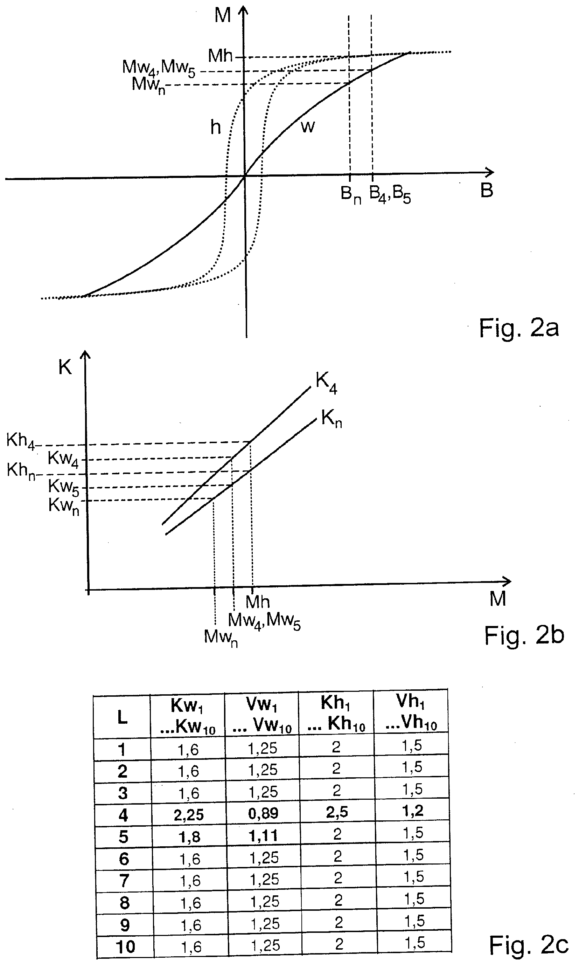

In Figur 2a ist die Magnetisierung M als Funktion des Magnetfelds B für hartmagnetisches und weichmagnetisches Magnetmaterial skizziert. Die Magnetisierungskurve h weist die für hartmagnetisches Magnetmaterial typische Hystereseform auf. Beispielhaft wird angenommen, dass bei den Messspuren L4 und L5 eine größere Magnetfeldstärke B₄ bzw. B₅ vorliegt als bei den anderen Messspuren des Magnetsensors (Bₙ), z.B. wegen Positionsschwankungen der Permanentmagnete des Magnetsensors. Da die Magnetisierung M des hartmagnetischen Magnetmaterials h bei einem Magnetfeld der Stärke Bₙ, aufgrund der Hystereseform, unempfindlich gegenüber Schwankungen der Magnetfeldstärke B ist, wirkt sich die Magnetfeldschwankung auf die Magnetisierung M des hartmagnetischen Magnetmaterials h kaum aus. Das hartmagnetische Magnetmaterial h erhält an allen Messspuren L1-L10 nahezu die gleiche Magnetisierung Mh. Die Magnetisierungskurve w des weichmagnetischen Magnetmaterials weist dagegen bei Bₙ eine deutliche Magnetfeldabhängigkeit auf. Das weichmagnetische Magnetmaterial erhält in den Messspuren L4 und L5 daher eine größere Magnetisierung Mw₄ bzw. Mw₅ als in den übrigen Messspuren, in denen das weichmagnetische Magnetmaterial w die Magnetisierung Mwₙ erreicht.

Die unterschiedliche Magnetisierung M der Magnetbereiche h, w des Kalibriermediums 1 wirkt sich auf die detektierten Kalibriermesswerte K aus, vgl. Figur 2b. Darüber hinaus kann aber z.B. auch die Empfindlichkeit der magnetosensitiven Elemente 11 der Messspuren L1-L10 des Magnetsensors 10 variieren. Beispielhaft wird angenommen, dass das magnetosensitive Element 11 der Messspur L4 - auch bei einer gleich großen Magnetisierung M des jeweiligen Magnetbereichs - ein größeres Magnetsignal liefert als die übrigen Messspuren L1-L3 und L5-L10, vgl. die in Fig. 2b dargestellten Funktionen K₄ und Kₙ. Die Magnetisierung Mh des hartmagnetischen Magnetbereichs h des Kalibriermediums 1 führt bei Messspur L4 daher zu einem größeren Kalibriermesswert Kh4 als bei den übrigen Messspuren, an denen der Kalibriermesswert Khₙ detektiert wird. Die Magnetisierung Mw₄ und Mw₅ des weichmagnetischen Magnetbereichs w führt bei den Messspuren L4 und L5 zu größeren Kalibriermesswerten Kw₄, Kw₅ als bei den übrigen Messspuren, an denen der Kalibriermesswert Kwₙ detektiert wird. Der Kalibriermesswert Kw₄ der Messspur L4 übersteigt dabei den der Messspur Kw₅ aufgrund der größeren Empfindlichkeit der Messspur L4.

In Figur 2c sind für jede Messspur L1-L10 beispielhaft Kalibriermesswerte Kw des weichmagnetischen Magnetbereichs und Kh des hartmagnetischen Magnetbereichs des Kalibriermediums 1 angegeben, die beim Kalibrieren des Magnetsensors 10 detektiert werden. Der jeweilige Kalibriermesswert Kw, Kh kann sich z.B. aus dem Mittelwert mehrerer Kalibriermesswerte des Kalibriermediums 1 ergeben. Zu einem Mittewert werden z.B. die von den vier linienförmigen Magnetbereichen h bzw. w erhaltenen Kalibriermesswerte zusammengefasst oder auch Kalibriermesswerte, die von mehreren gleichartigen Kalibriermedien erhalten werden, die nacheinander an dem Magnetsensor vorbeitransportiert und detektiert werden. Dem Kalibriermedium 1 sind Sollwerte für den Kalibriermesswert Kw und für den Kalibriermesswert Kh zugeordnet. Zum Beispiel wurde für den Kalibriermesswert Kw für alle Messspuren L1-L10 der Sollwert Kw0=1,6 und für den Kalibriermesswert Kh für alle Messspuren L1-L10 der Sollwert Kh0=2,0 vorgegeben. Bei der Kalibrierung wird in den Messspuren L1-L3 und L6-L10 ein Kalibriermesswert Kw, Kh detektiert, der dem Sollwert entspricht. In den Messspuren L4 und L5 gibt es dagegen deutliche Abweichungen von diesen Sollwerten.

Nach dieser Kalibrierung wird, sofern nötig bzw. gewünscht, eine Justage des Magnetsensors durchgeführt. Die Justage wird z.B. dann durchgeführt, wenn die detektierten Kalibriermesswerte eine zu große Abweichung von den Sollwerten Kw0, Kh0 aufweisen. Wenn die akzeptable Abweichung für die detektierten Kalibriermesswerte Kw, Kh z.B. bei +-10% um den jeweiligen Sollwert Kw0, Kh0 beträgt, so liegen die ersten Kalibriermesswerte Kw der Messspuren L4 und L5 und der zweite Kalibriermesswert Kh der Messspur L4 außerhalb des Akzeptanzbereichs.

Zur Justage wird aus dem jeweiligen Kalibriermesswert Kw ein neuer erster Kalibrierparameter Vw und aus dem jeweiligen Kalibriermesswert Kh ein neuer zweiter Kalibrierparameter Vh berechnet, der den bisherigen ersetzt. Da die Messspuren L4 und L5 erhöhte erste Kalibriermesswerte Kw und L4 einen erhöhten zweiten Kalibriermesswert Kh liefert, erhält man für diese Messspuren entsprechend reduzierte neue Kalibrierparameter, vgl. Figur 2c. Die so erhaltenen neuen Kalibrierparameter werden anschließend in den Datenspeicher 5 abgelegt und ersetzen dort den jeweiligen Ausgangswert, so dass sie bei der Prüfung der Wertdokumente zu Verfügung stehen. Die bei der Justage ermittelten Kalibrierparameter Vw, Vh werden anschließend dazu verwendet, die Messabweichungen auszugleichen, denen das detektierte Magnetsignal eines Wertdokuments unterworfen ist.

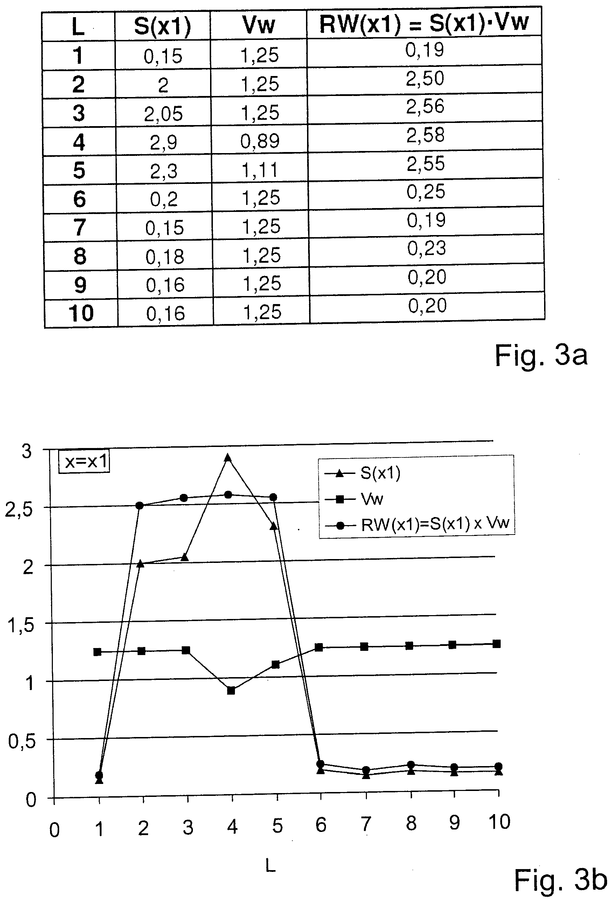

Anhand der Figuren 3a-d wird deutlich, wie sich die Justage des Magnetsensors 10 auf die Magnetsignale S des Magnetsensors auswirkt. In der Tabelle der Figur 3a ist für jede Messspur L1-L10 beispielhaft das Magnetsignal S(x1) eingetragen, das der Magnetsensor 10 an der Position x1 von dem Wertdokument 2a detektiert, und in der Tabelle der Figur 3b das Magnetsignal S(x2), das der Magnetsensor 10 an der Position x2 detektiert.

Im Datenspeicher 5 des Magnetsensors 10 sind die Informationen dazu enthalten, an welchen Koordinaten x, y des Wertdokument 2a welcher Kalibrierparameter Vw, Vh zu verwenden ist, vgl. Figur 1b. Ferner sind dort für jede Messspur die jeweiligen Zahlenwerte Kw, Vw, Kh, Vh gespeichert (Tabelle aus Figur 2c). Das Wertdokument 2a gehört zu einer Wertdokumentart a, für die in dem Datenspeicher 5 die in der folgenden Tabelle 1 angegebenen Informationen hinterlegt sind. Die für ein Wertdokument 2b einer anderen Wertdokumentart b zu verwendenden Kalibrierparameter Vw, Vh sind in Tabelle 2 angegeben. An der Position x1 der Wertdokumente des Wertdokumentart a ist gemäß Tabelle 1 bei allen Messspuren L1-L10 der jeweilige Kalibrierparameter Vw zu verwenden, und an der Position x2 bei allen Messspuren L1-L10 der jeweilige Kalibrierparameter Vh. Bei Wertdokumenten 2b der Wertdokumentart b ist gemäß Tabelle 2 an der Position x1 bei den Messspuren L1-L5 der jeweilige Kalibrierparameter Vw, bei den Messspuren L6-L10 der jeweilige Kalibrierparameter Vh, und an der Position x2 bei allen Messspuren L1-L10 der jeweilige Kalibrierparameter Vh zu verwenden. Natürlich können die Kalibrierparameter auch noch für weitere x-Positionen des Wertdokuments 2a und für weitere Wertdokumentarten vorliegen.

### Wertdokumentart a:

**Tabelle 1**

| | | |
|---|---|---|
| Position x1 | Messspuren L1-L10 | Kalibrierparameter Vw |
| Position x2 | Messspuren L1-L10 | Kalibrierparameter Vh |

### Wertdokumentart b:

**Tabelle 2**

| | | |
|---|---|---|
| Position x1 | Messspuren L1-L5 | Kalibrierparameter Vw |
| Position x1 | Messspuren L6-L10 | Kalibrierparameter Vh |
| Position x2 | Messspuren L1-L10 | Kalibrierparameter Vw |
| Position x3 | ··· | ··· |
| ··· | ··· | ··· |

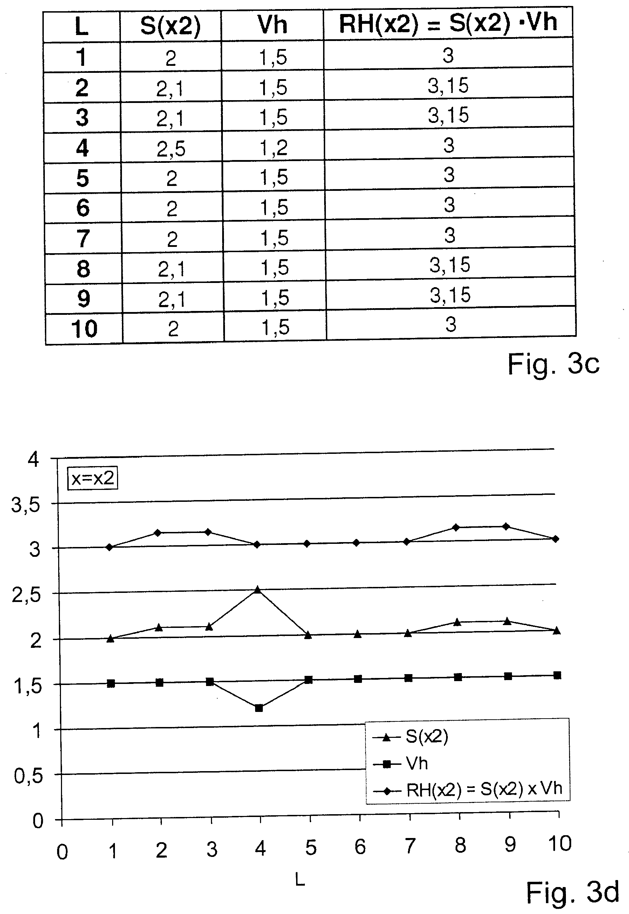

Bei der Auswertung der detektierten Magnetsignale des Wertdokuments werden für jede Messspur, in Abhängigkeit der Position (x, y) auf dem Wertdokument, der jeweils angegebene Kalibrierparameter Vw oder Vh verwendet, um das jeweils detektierte Magnetsignal S(x, y) in ein resultierendes Magnetsignal RW(x, y) oder RH(x, y) umzurechnen, vgl. Figuren 3a, 3c. Im vorliegenden Beispiel ist dies nur für die zwei x-Positionen x1, x2 des Wertdokuments 2a gezeigt.

Bei dem Wertdokument 2a werden beispielsweise die Magnetsignale S(x1) aller Messspuren L1-L10 mit dem jeweiligen Kalibrierparameter Vw multipliziert, woraus sich das resultierende Magnetsignal RW(x1) ergibt, vgl. Figur 3a. Und die Magnetsignale S(x2) aller Messspuren L1-L10 werden mit dem jeweiligen Kalibrierparameter Vh multipliziert, woraus sich das resultierende Magnetsignal RH(x2) ergibt, vgl. Figur 3c. In Figur 3b ist, für die Position x1 des Wertdokuments 2a, das detektierte Magnetsignal S(x1) des dort befindlichen weichmagnetischen Magnetbereichs W sowie der bei x1 jeweils zu verwendende Kalibrierparameter Vw und das resultierende Magnetsignal RW(x1) des weichmagnetischen Magnetbereichs W für die einzelnen Messspuren L1-L10 dargestellt. In Figur 3d ist, für die Position x2 des Wertdokuments, das detektierte Magnetsignal S(x2) des dort befindlichen hartmagnetischen Magnetbereichs H sowie der bei x2 jeweils zu verwendende Kalibrierparameter Vh und das resultierende Magnetsignal RH(x2) des hartmagnetischen Magnetbereichs H für die einzelnen Messspuren L1-L10 dargestellt. Ein Vergleich der resultierenden Magnetsignale RW(x1) mit S(x1) und RH(x2) mit S(x2) zeigt, dass die durch den Magnetsensor 10 zustande kommenden Messabweichungen, die das detektierte Magnetsignal S(x1) und S(x2) verfälschen würden, mit Hilfe der Kalibrierparameter Vw und Vh wieder berichtigt werden.

## Patentansprüche

1. Magnetsensor (10) zum Prüfen von Wertdokumenten, die zum Prüfen entlang einer Transportrichtung (T) an dem Magnetsensor (10) vorbeitransportiert werden, **dadurch gekennzeichnet, dass**
- der Magnetsensor (10) mindestens einen ersten Kalibrierparameter (Vw) und mindestens einen von dem/den ersten Kalibrierparameter/n unabhängigen zweiten Kalibrierparameter (Vh) aufweist, wobei
- der erste Kalibrierparameter (Vw) dazu vorgesehen ist, ein Magnetsignal (S) des Magnetsensors zu berichtigen, das der Magnetsensor, beim Prüfen eines Wertdokuments, von einem weichmagnetischen Magnetbereich (W) des zu prüfenden Wertdokuments (2a) detektiert, und
- der zweite Kalibrierparameter (Vh) dazu vorgesehen ist, ein Magnetsignal (S) des Magnetsensors zu berichtigen, das der Magnetsensor, beim Prüfen eines Wertdokuments, von einem hartmagnetischen Magnetbereich (H) des zu prüfenden Wertdokuments (2a) detektiert, und wobei
- der Magnetsensor dazu eingerichtet ist, ein Magnetsignal des Magnetsensors (S), das dieser von einem zu prüfenden Wertdokument detektiert, entweder mit einem der ersten Kalibrierparameter (Vw) oder mit einem der zweiten Kalibrierparameter (Vh) zu berichtigen, wobei der Magnetsensor dazu eingerichtet ist, ein von einem weichmagnetischen Bereich des zu prüfenden Wertdokuments detektiertes Magnetsignal mit einem der ersten Kalibrierparameter (Vw) zu berichtigen, und ein von einem hartmagnetischen Bereich des zu prüfenden Wertdokuments detektiertes Magnetsignal mit einem der zweiten Kalibrierparameter (Vh) zu berichtigen, und
- der Magnetsensor einen Datenspeicher (5) aufweist, in dem der mindestens eine erste Kalibrierparameter (Vw) und der mindestens eine zweite Kalibrierparameter (Vh) des Magnetsensors hinterlegt sind, wobei in dem Datenspeicher (5) Informationen enthalten sind, die bestimmen, welche der Magnetsignale (S), die der Magnetsensor von einem Wertdokument detektiert, mit dem ersten Kalibrierparameter (Vw) zu berichtigen sind und welche der Magnetsignale (S), die der Magnetsensor von einem Wertdokument detektiert, mit dem zweiten Kalibrierparameter (Vh) zu berichtigen sind.

2. Magnetsensor nach Anspruch 1, **dadurch gekennzeichnet, dass** der Magnetsensor dazu eingerichtet ist, das detektierte Magnetsignal eines Wertdokuments (2a) in Abhängigkeit der Position (x, y) auf dem Wertdokument, an der der Magnetsensor das Magnetsignal (S) detektiert, und/oder in Abhängigkeit der Wertdokumentart (a, b) des zu prüfenden Wertdokuments, wahlweise mit dem ersten Kalibrierparameter (Vw) oder mit dem zweiten Kalibrierparameter (Vh) zu berichtigen.

3. Magnetsensor nach einem der vorhergehenden Ansprüche, **dadurch gekennzeichnet, dass** der Magnetsensor mehrere Messspuren (L1-L10) aufweist, durch die der Magnetsensor ein Magnetsignal (S) an mehreren Positionen (y) quer zur Transportrichtung (T) des Wertdokuments detektieren kann, und dass der Magnetsensor pro Messspur (L1-L10) jeweils sowohl einen ersten Kalibrierparameter (Vw) als auch einen zweiten Kalibrierparameter (Vh) aufweist, der von dem ersten Kalibrierparameter der jeweiligen Messspur (L1-L10) unabhängig ist.

4. Magnetsensor nach einem der vorhergehenden Ansprüche, **dadurch gekennzeichnet, dass** der Magnetsensor (10) eine Auswerteeinrichtung (4) aufweist, durch die die detektierten Magnetsignale (S) des Magnetsensors mittels einer Auswertesoftware (6) verarbeitet und ausgewertet werden können, wobei die Auswertesoftware (6) dazu ausgebildet ist, in Abhängigkeit davon, ob das Magnetsignal (S) von einem weichmagnetischen Magnetbereich (W) eines Wertdokuments oder von einem hartmagnetischen Magnetbereich (H) eines Wertdokuments detektiert wird, das jeweilige Magnetsignal (S) entweder auf Basis des ersten (Vw) oder auf Basis des zweiten Kalibrierparameters (Vh) zu berichtigen.

5. Magnetsensor nach einem der vorhergehenden Ansprüche, **dadurch gekennzeichnet, dass** der Magnetsensor einen konfigurierbaren elektronischen Verstärker (12) zum Verstärken der detektierten Magnetsignale (S) aufweist, der dazu ausgebildet ist, bei der Prüfung eines Wertdokuments, in Abhängigkeit davon, ob das Magnetsignal (S) von einem weichmagnetischen Magnetbereich (W) eines Wertdokuments oder von einem hartmagnetischen Magnetbereich (H) eines Wertdokuments detektiert wird, die Höhe seiner Verstärkung entweder auf Basis des ersten Kalibrierparameters (Vw) oder auf Basis des zweiten Kalibrierparameters (Vh) einzustellen.

6. Magnetsensor nach einem der vorhergehenden Ansprüche, **dadurch gekennzeichnet, dass** der Magnetsensor mindestens ein konfigurierbares magnetosensitives Element (11) aufweist, dessen Empfindlichkeit konfigurierbar ist und dass, bei der Prüfung eines Wertdokuments, die Empfindlichkeit des mindestens einen magnetosensitiven Elements (11) in Abhängigkeit davon, ob das Magnetsignal von einem weichmagnetischen Magnetbereich (W) eines Wertdokuments oder von einem hartmagnetischen Magnetbereich (H) eines Wertdokuments detektiert wird, entweder auf Basis des ersten (Vw) oder auf Basis des zweiten Kalibrierparameters (Vh) eingestellt wird.

7. Magnetsensor nach einem der vorhergehenden Ansprüche, **dadurch gekennzeichnet, dass** der Magnetsensor (10) einen Kalibriermodus aufweist, in dem der Magnetsensor mindestens einen ersten und mindestens einen zweiten Kalibriermesswert (Kw, Kh) eines Kalibriermediums (1) detektieren und die detektierten Kalibriermesswerte weiterverarbeiten kann, um die Funktion des Magnetsensors (10) anhand des detektierten ersten und zweiten Kalibriermesswerts (Kw, Kh) zu überprüfen, wobei nach dem Überprüfen der Funktion des Magnetsensors (10), in Abhängigkeit des Ergebnisses der Überprüfung ggf. eine Justage des Magnetsensors (10) durchgeführt wird, bei der der erste Kalibrierparameter (Vw) anhand des detektierten ersten Kalibriermesswerts (Kw) ermittelt wird und/ oder der zweite Kalibrierparameter (Vh) anhand des detektierten zweiten Kalibriermesswerts (Kh) ermittelt wird, wobei der Magnetsensor (10) insbesondere dazu eingerichtet ist, im Kalibriermodus das Kalibrierverfahren nach einem der Ansprüche 9 bis 12 auszuführen.

8. Vorrichtung zur Bearbeitung von Wertdokumenten, die einen Magnetsensor (10) nach einem der Ansprüche 1 bis 7 aufweist.

9. Verfahren zum Kalibrieren eines Magnetsensors (10), der zum Prüfen von Wertdokumenten ausgebildet ist, die zum Prüfen entlang einer Transportrichtung (T) an dem Magnetsensor (10) vorbeitransportiert werden, wobei der Magnetsensor
- mindestens einen ersten Kalibrierparameter (Vw) aufweist, der dazu vorgesehen ist, ein Magnetsignal (S) des Magnetsensors zu berichtigen, das der Magnetsensor, beim Prüfen eines Wertdokuments, von einem weichmagnetischen Magnetbereich (W) des zu prüfenden Wertdokuments (2a) detektiert, und
- mindestens einen von dem/den ersten Kalibrierparameter/n unabhängigen zweiten Kalibrierparameter (Vh) aufweist, der dazu vorgesehen ist, ein Magnetsignal (S) des Magnetsensors zu berichtigen, das der Magnetsensor, beim Prüfen eines Wertdokuments, von einem hartmagnetischen Magnetbereich (H) des zu prüfenden Wertdokuments (2a) detektiert, und
- dazu eingerichtet ist, ein Magnetsignal des Magnetsensors (S), das dieser von einem zu prüfenden Wertdokument detektiert, entweder mit einem der ersten Kalibrierparameter (Vw) oder mit einem der zweiten Kalibrierparameter (Vh) zu berichtigen, wobei der Magnetsensor dazu eingerichtet ist, ein von einem weichmagnetischen Bereich des Wertdokuments detektiertes Magnetsignal mit einem der ersten Kalibrierparameter (Vw) zu berichtigen, und ein von einem hartmagnetischen Bereich des Wertdokuments detektiertes Magnetsignal mit einem der zweiten Kalibrierparameter (Vh) zu berichtigen,
- einen Datenspeicher (5) aufweist, in dem der mindestens eine erste Kalibrierparameter (Vw) und der mindestens eine zweite Kalibrierparameter (Vh) des Magnetsensors hinterlegt sind, wobei in dem Datenspeicher (5) Informationen enthalten sind, die bestimmen, welche der Magnetsignale (S), die der Magnetsensor von einem Wertdokument detektiert, mit dem ersten Kalibrierparameter (Vw) zu berichtigen sind und welche der Magnetsignale (S), die der Magnetsensor von einem Wertdokument detektiert, mit dem zweiten Kalibrierparameter (Vh) zu berichtigen sind,
wobei beim Kalibrieren des Magnetsensors
- der Magnetsensor (10) mindestens einen ersten Kalibriermesswert von einem weichmagnetischen Magnetbereich (w) detektiert, der in/auf einem Kalibriermedium (1) vorhanden ist, das zum Kalibrieren des Magnetsensors entlang einer Transportrichtung (T) an dem Magnetsensor (10) vorbeitransportiert wird, und/ oder
- der Magnetsensor (10) mindestens einen zweiten Kalibriermesswert (Kh) von einem hartmagnetischen Magnetbereichs (h) detektiert, der in/auf einem Kalibriermedium (1) vorhanden ist, das zum Kalibrieren des Magnetsensors entlang einer Transportrichtung (T) an dem Magnetsensor (10) vorbeitransportiert wird, und
- der detektierte erste und/ oder zweite Kalibriermesswert (Kw, Kh) weiterverarbeitet werden, um die Funktion des Magnetsensors (10) anhand des detektierten ersten und zweiten Kalibriermesswerts (Kw, Kh) zu überprüfen, wobei nach dem Überprüfen der Funktion des Magnetsensors (10), in Abhängigkeit des Ergebnisses der Überprüfung ggf. eine Justage des Magnetsensors (10) durchgeführt wird, bei der der erste Kalibrierparameter (Vw) anhand des detektierten ersten Kalibriermesswerts (Kw) ermittelt wird und/oder der zweite Kalibrierparameter (Vh) anhand des detektierten zweiten Kalibriermesswerts (Kh) ermittelt wird.

10. Verfahren nach Anspruch 9, **dadurch gekennzeichnet, dass** beim Überprüfen der Funktion des Magnetsensors (10) überprüft wird, ob der detektierte erste Kalibriermesswert (Kw) innerhalb eines Akzeptanzbereichs um einen ersten Sollwert (Kw0) liegt und ob der detektierte zweite Kalibriermesswert (Kh) innerhalb eines Akzeptanzbereichs um einen zweiten Sollwert (Kh0) liegt, und insbesondere nur dann eine Justage des Magnetsensors (10) durchgeführt wird, falls der detektierte erste und/oder zweite Kalibriermesswert (Kw, Kh) außerhalb des jeweiligen Akzeptanzbereichs um den jeweiligen Sollwert (Kw0, Kh0) liegt.

11. Verfahren nach einem oder mehreren der Ansprüche 9 bis 10, **dadurch gekennzeichnet, dass**, nach der Überprüfung der Funktion des Magnetsensors (10), optional eine Justage des Magnetsensors durchgeführt wird, falls eine Bedienperson, der das Ergebnis der Überprüfung mitgeteilt wird, die Justage auslöst.

12. Verfahren nach einem oder mehreren der Ansprüche 9 bis 11, **dadurch gekennzeichnet, dass**
- der erste Kalibrierparameter (Vw) unverändert bleibt, falls die Überprüfung der Funktion des Magnetsensors ergibt, dass der detektierte erste Kalibriermesswert (Kw) innerhalb des Akzeptanzbereichs liegt, und, falls die Überprüfung ergibt, dass der detektierte erste Kalibriermesswert (Kw) außerhalb des Akzeptanzbereichs liegt, dass der erste Kalibrierparameter (Vw) auf Basis des detektierten ersten Kalibriermesswerts (Kw) neu ermittelt wird und der bisherige erste Kalibrierparameter durch den neu ermittelten ersetzt wird, und
- der zweite Kalibrierparameter (Vh) unverändert bleibt, falls die Überprüfung der Funktion des Magnetsensors ergibt, dass der detektierte zweite Kalibriermesswert (Kh) innerhalb des Akzeptanzbereichs liegt, und, falls die Überprüfung ergibt, dass der detektierte zweite Kalibriermesswert (Kh) außerhalb des Akzeptanzbereichs liegt, dass ein zweiter Kalibrierparameter (Vh) anhand des detektierten zweiten Kalibriermesswerts (Kh) neu ermittelt wird und der bisherige zweite Kalibrierparameter durch den neu ermittelten ersetzt wird.

13. Verfahren zur Prüfung eines Wertdokuments (2a) durch einen Magnetsensor (10), der zum Prüfen von Wertdokumenten ausgebildet ist, die zum Prüfen entlang einer Transportrichtung (T) an dem Magnetsensor (10) vorbeitransportiert werden, wobei der Magnetsensor
- mindestens einen ersten Kalibrierparameter (Vw) aufweist, der dazu vorgesehen ist, ein Magnetsignal (S) des Magnetsensors zu berichtigen, das der Magnetsensor, beim Prüfen eines Wertdokuments, von einem weichmagnetischen Magnetbereich (W) des zu prüfenden Wertdokuments (2a) detektiert, und
- mindestens einen von dem/den ersten Kalibrierparameter/n unabhängigen zweiten Kalibrierparameter (Vh) aufweist, der dazu vorgesehen ist, ein Magnetsignal (S) des Magnetsensors zu berichtigen, das der Magnetsensor, beim Prüfen eines Wertdokuments, von einem hartmagnetischen Magnetbereich (H) des zu prüfenden Wertdokuments (2a) detektiert, und
- dazu eingerichtet ist, ein Magnetsignal des Magnetsensors (S), das dieser von einem zu prüfenden Wertdokument detektiert, entweder mit einem der ersten Kalibrierparameter (Vw) oder mit einem der zweiten Kalibrierparameter (Vh) zu berichtigen, wobei der Magnetsensor dazu eingerichtet ist, ein von einem weichmagnetischen Bereich des Wertdokuments detektiertes Magnetsignal mit einem der ersten Kalibrierparameter (Vw) zu berichtigen, und ein von einem hartmagnetischen Bereich des Wertdokuments detektiertes Magnetsignal mit einem der zweiten Kalibrierparameter (Vh) zu berichtigen, und
- einen Datenspeicher (5) aufweist, in dem der mindestens eine erste Kalibrierparameter (Vw) und der mindestens eine zweite Kalibrierparameter (Vh) des Magnetsensors hinterlegt sind, wobei in dem Datenspeicher (5) Informationen enthalten sind, die bestimmen, welche der Magnetsignale (S), die der Magnetsensor von einem Wertdokument detektiert, mit dem ersten Kalibrierparameter (Vw) zu berichtigen sind und welche der Magnetsignale (S), die der Magnetsensor von einem Wertdokument detektiert, mit dem zweiten Kalibrierparameter (Vh) zu berichtigen sind, wobei zur Prüfung eines Wertdokuments (2a), das mindestens einen weichmagnetischen Magnetbereich (W) und/oder mindestens einen hartmagnetischen Magnetbereich (H) aufweist, folgende Schritte durchgeführt werden:
- Vorbeitransportieren des Wertdokuments (2a) an dem Magnetsensor (10) entlang der Transportrichtung (T), wobei der Magnetsensor (10) Magnetsignale (S) von dem weichmagnetischen Magnetbereich (W) des Wertdokuments detektiert und / oder wobei der Magnetsensor (10) Magnetsignale (S) von dem hartmagnetischen Magnetbereich (H) des Wertdokuments detektiert, und
- Berichtigen der von dem weichmagnetischen Magnetbereich (W) detektierten Magnetsignale (S) mit Hilfe des ersten Kalibrierparameters (Vw), um Messabweichungen des Magnetsensors auszugleichen, mit welchen die Magnetsignale (S), die der Magnetsensor von dem weichmagnetischen Magnetbereich (W) des Wertdokuments detektiert, behaftet sind und Verwenden des mit Hilfe des ersten Kalibrierparameters (Vw) berichtigten Magnetsignals (RW) des weichmagnetischen Magnetbereichs (W) zum Prüfen des Wertdokuments (2a),
und/ oder
Berichtigen der von dem hartmagnetischen Magnetbereich (H) detektierten Magnetsignale (S) mit Hilfe des zweiten Kalibrierparameters (Vh), um Messabweichungen des Magnetsensors auszugleichen, mit welchen die Magnetsignale (S), die der Magnetsensor von dem hartmagnetischen Magnetbereich (H) des Wertdokuments detektiert, behaftet sind, und Verwenden des mit Hilfe des mit dem zweiten Kalibrierparameter (Vh) berichtigen Magnetsignals (RH) des hartmagnetischen Magnetbereichs (H) zum Prüfen des Wertdokuments (2a).

## Claims

1. A magnetic sensor (10) for checking value documents which are transported, for checking, past the magnetic sensor (10) along a transport direction (T), **characterized in that**
- the magnetic sensor (10) has at least one first calibrating parameter (Vw) and at least one second calibrating parameter (Vh) independent of the first calibrating parameter/ s, wherein
- the first calibrating parameter (Vw) is provided for correcting a magnetic signal (S) of the magnetic sensor which the magnetic sensor, upon the check of a value document, detects from a soft-magnetic magnetic region (W) of the value document (2a) to be checked, and
- the second calibrating parameter (Vh) is provided for correcting a magnetic signal (S) of the magnetic sensor which the magnetic sensor, upon the check of a value document, detects from a hard-magnetic magnetic region (H) of the value document (2a) to be checked, and wherein
- the magnetic sensor is arranged for correcting a magnetic signal of the magnetic sensor (S) that the latter detects from a value document to be checked, either with one of the first calibrating parameters (Vw) or with one of the second calibrating parameters (Vh), wherein the magnetic sensor is arranged for correcting a magnetic signal detected from a soft-magnetic region of the value document to be checked with one of the first calibrating parameters (Vw) and for correcting a magnetic signal detected from a hard-magnetic region of the value document to be checked with one of the second calibrating parameters (Vh), and
- the magnetic sensor has a data memory (5) in which the at least one first calibrating parameter (Vw) and the at least one second calibrating parameter (Vh) of the magnetic sensor are deposited, wherein the data memory (5) contains information which determines which of the magnetic signals (S) that the magnetic sensor detects from a value document are to be corrected with the first calibrating parameter (Vw) and which of the magnetic signals (S) that the magnetic sensor detects from a value document are to be corrected with the second calibrating parameter (Vh).

2. The magnetic sensor according to claim 1, **characterized in that** the magnetic sensor is arranged for correcting the detected magnetic signal of a value document (2a) in dependence on the position (x, y) on the value document at which the magnetic sensor detects the magnetic signal (S), and/or in dependence on the value-document type (a, b) of the value document to be checked, electively with the first calibrating parameter (Vw) or with the second calibrating parameter (Vh).

3. The magnetic sensor according to any of the previous claims, **characterized in that** the magnetic sensor has a plurality of measuring tracks (L1-L10) through which the magnetic sensor can detect a magnetic signal (S) at a plurality of positions (y) transverse to the transport direction (T) of the value document, and that the magnetic sensor respectively has per measuring track (L1-L10) both a first calibrating parameter (Vw) and a second calibrating parameter (Vh) which is independent of the first calibrating parameter of the respective measuring track (L1-L10).

4. The magnetic sensor according to any of the previous claims, **characterized in that** the magnetic sensor (10) has an evaluation device (4) through which the detected magnetic signals (S) of the magnetic sensor can be processed and evaluated by means of evaluation software (6), wherein the evaluation software (6) is designed for correcting the respective magnetic signal (S) either on the basis of the first (Vw) or on the basis of the second calibrating parameter (Vh) in dependence on whether the magnetic signal (S) is detected from a soft-magnetic magnetic region (W) of a value document or from a hard-magnetic magnetic region (H) of a value document.

5. The magnetic sensor according to any of the previous claims, **characterized in that** the magnetic sensor has a configurable electronic amplifier (12) for amplifying the detected magnetic signals (S), which is designed for setting, upon the check of a value document, the amount of amplification of a magnetic signal (S) either on the basis of the first calibrating parameter (Vw) or on the basis of the second calibrating parameter (Vh) in dependence on whether said signal is detected from a soft-magnetic magnetic region (W) of a value document or from a hard-magnetic magnetic region (H) of a value document.

6. The magnetic sensor according to any of the previous claims, **characterized in that** the magnetic sensor has at least one configurable magnetosensitive element (11) whose sensitivity is configurable and that, upon the check of a value document, the sensitivity of the at least one magnetosensitive element (11) is set either on the basis of the first (Vw) or on the basis of the second calibrating parameter (Vh) in dependence on whether the magnetic signal is detected from a soft-magnetic magnetic region (W) of a value document or from a hard-magnetic magnetic region (H) of a value document.

7. The magnetic sensor according to any of the previous claims, **characterized in that** the magnetic sensor (10) has a calibrating mode in which the magnetic sensor can detect at least one first and at least one second calibration measurement value (Kw, Kh) of a calibration medium (1) and further process the detected calibration measurement values in order to test the function of the magnetic sensor (10) using the detected first and second calibration measurement value (Kw, Kh), wherein after the testing of the function of the magnetic sensor (10) there is carried out, where applicable, an adjustment of the magnetic sensor (10) in dependence on the result of the test, upon which the first calibrating parameter (Vw) is established using the detected first calibration measurement value (Kw) and/or the second calibrating parameter (Vh) is established using the detected second calibration measurement value (Kh), wherein the magnetic sensor (10) is arranged in particular for performing the calibrating method according to any of claims 9 to 12 in the calibrating mode.

8. An apparatus for processing value documents which has a magnetic sensor (10) according to any of claims 1 to 7.

9. A method for calibrating a magnetic sensor (10) which is designed for checking value documents which are transported, for checking, past the magnetic sensor (10) along a transport direction (T), wherein the magnetic sensor
- has at least one first calibrating parameter (Vw) which is provided for correcting a magnetic signal (S) of the magnetic sensor which the magnetic sensor, upon the check of a value document, detects from a soft-magnetic magnetic region (W) of the value document (2a) to be checked, and
- has at least one second calibrating parameter (Vh) independent of the first calibrating parameter/s, which is provided for correcting a magnetic signal (S) of the magnetic sensor which the magnetic sensor, upon the check of a value document, detects from a hard-magnetic magnetic region (H) of the value document (2a) to be checked, and
- is arranged for correcting a magnetic signal of the magnetic sensor (S) that the latter detects from a value document to be checked, either with one of the first calibrating parameters (Vw) or with one of the second calibrating parameters (Vh), wherein the magnetic sensor is arranged for correcting a magnetic signal detected from a soft-magnetic region of the value document with one of the first calibrating parameters (Vw) and for correcting a magnetic signal detected from a hard-magnetic region of the value document with one of the second calibrating parameters (Vh),
- has a data memory (5) in which the at least one first calibrating parameter (Vw) and the at least one second calibrating parameter (Vh) of the magnetic sensor are deposited, wherein the data memory (5) contains information which determines which of the magnetic signals (S) that the magnetic sensor detects from a value document are to be corrected with the first calibrating parameter (Vw) and which of the magnetic signals (S) that the magnetic sensor detects from a value document are to be corrected with the second calibrating parameter (Vh),
wherein upon calibrating the magnetic sensor
- the magnetic sensor (10) detects at least one first calibration measurement value from a soft-magnetic magnetic region (w) which is present in/on a calibration medium (1) which, for calibrating the magnetic sensor, is transported past the magnetic sensor (10) along a transport direction (T), and/or
- the magnetic sensor (10) detects at least one second calibration measurement value (Kh) from a hard-magnetic magnetic region (h) which is present in/on a calibration medium (1) which, for calibrating the magnetic sensor, is transported past the magnetic sensor (10) along a transport direction (T), and
- the detected first and/or second calibration measurement value (Kw, Kh) are further processed in order to test the function of the magnetic sensor (10) based on the detected first and second calibration measurement value (Kw, Kh), wherein after the testing of the function of the magnetic sensor (10) there is carried out, in dependence on the result of the testing, where applicable, an adjustment of the magnetic sensor (10) upon which the first calibrating parameter (Vw) is established using the detected first calibration measurement value (Kw) and/or the second calibrating parameter (Vh) is established using the detected second calibration measurement value (Kh).

10. The method according to claim 9, **characterized in that** upon the testing of the function of the magnetic sensor (10) it is tested whether the detected first calibration measurement value (Kw) lies within an acceptance range around a first target value (Kw0) and/ or whether the detected second calibration measurement value (Kh) lies within an acceptance range around a second target value (Kh0), and an adjustment of the magnetic sensor (10) is in particular only carried out if the detected first and/or second calibration measurement value (Kw, Kh) lies outside the respective acceptance range around the respective target value (Kw0, Kh0).

11. The method according to one or more of claims 9 to 10, **characterized in that**, after the test of the function of the magnetic sensor (10) an adjustment of the magnetic sensor is optionally carried out if an operating person to whom the result of the test is communicated triggers the adjustment.

12. The method according to one or more of claims 9 to 11, **characterized in that**
- the first calibrating parameter (Vw) remains unchanged if the test of the function of the magnetic sensor yields that the detected first calibration measurement value (Kw) lies within the acceptance range, and if the test yields that the detected first calibration measurement value (Kw) lies outside the acceptance range the first calibrating parameter (Vw) is newly established on the basis of the detected first calibration measurement value (Kw) and the previous first calibrating parameter is replaced by the newly established one, and
- the second calibrating parameter (Vh) remains unchanged if the test of the function of the magnetic sensor yields that the detected second calibration measurement value (Kh) lies within the acceptance range, and if the test yields that the detected second calibration measurement value (Kh) lies outside the acceptance range the second calibrating parameter (Vh) is newly established using the detected second calibration measurement value (Kh) and the previous second calibrating parameter is replaced by the newly established one.

13. A method for checking a value document (2a) by a magnetic sensor (10) which is designed for checking value documents which are transported, for checking, past the magnetic sensor (10) along a transport direction (T), wherein the magnetic sensor (10)
- has at least one first calibrating parameter (Vw) which is provided for correcting a magnetic signal (S) of the magnetic sensor which the magnetic sensor, upon the check of a value document, detects from a soft-magnetic magnetic region (W) of the value document (2a) to be checked, and
- has at least one second calibrating parameter (Vh) independent of the first calibrating parameter/s, which is provided for correcting a magnetic signal (S) of the magnetic sensor which the magnetic sensor, upon the check of a value document, detects from a hard-magnetic magnetic region (H) of the value document (2a) to be checked, and
- is arranged for correcting a magnetic signal of the magnetic sensor (S) that the latter detects from a value document to be checked, either with one of the first calibrating parameters (Vw) or with one of the second calibrating parameters (Vh), wherein the magnetic sensor is arranged for correcting a magnetic signal detected from a soft-magnetic region of the value document with one of the first calibrating parameters (Vw) and for correcting a magnetic signal detected from a hard-magnetic region of the value document with one of the second calibrating parameters (Vh), and
- has a data memory (5) in which the at least one first calibrating parameter (Vw) and the at least one second calibrating parameter (Vh) of the magnetic sensor are deposited, wherein the data memory (5) contains information which determines which of the magnetic signals (S) that the magnetic sensor detects from a value document are to be corrected with the first calibrating parameter (Vw) and which of the magnetic signals (S) that the magnetic sensor detects from a value document are to be corrected with the second calibrating parameter (Vh),
wherein for checking a value document (2a) that has at least one soft-magnetic magnetic region (W) and/or at least one hard-magnetic magnetic region (H) the following steps are carried out:
- transporting the value document (2a) past the magnetic sensor (10) along the transport direction (T), with the magnetic sensor (10) detecting magnetic signals (S) from the soft-magnetic magnetic region (W) of the value document and/or with the magnetic sensor (10) detecting magnetic signals (S) from the hard-magnetic magnetic region (H) of the value document, and
- correcting the magnetic signals (S) detected from the soft-magnetic magnetic region (W) using the first calibrating parameter (Vw), in order to compensate the magnetic sensor's measurement deviations exhibited by the magnetic signals (S) that the magnetic sensor detects from the soft-magnetic magnetic region (W) of the value document, and employing the magnetic signal (RW) of the soft-magnetic magnetic region (W) corrected using the first calibrating parameter (Vw) for checking the value document (2a),
and/ or
correcting the magnetic signals (S) detected from the hard-magnetic magnetic region (H) using the second calibrating parameter (Vh), in order to compensate the magnetic sensor's measurement deviations exhibited by the magnetic signals (S) that the magnetic sensor detects from the hard-magnetic magnetic region (H) of the value document, and employing the magnetic signal (RH) of the hard-magnetic magnetic region (H) corrected using the second calibrating parameter (Vh) for checking the value document (2a).

## Revendications

1. Capteur magnétique (10) destiné à l'examen de documents de valeur transportés pour l'examen le long d'une direction de transport (T) en passant par le capteur magnétique (10), **caractérisé en ce que**
- le capteur magnétique (10) comporte au moins un premier paramètre d'étalonnage (Vw) et au moins un deuxième paramètre d'étalonnage (Vh), indépendant du/des premier(s) paramètre(s) d'étalonnage, cependant que
- le premier paramètre d'étalonnage (Vw) est prévu pour rectifier un signal magnétique (S) du capteur magnétique que le capteur magnétique, lors de l'examen d'un document de valeur, détecte d'une zone magnétique magnétiquement douce (W) du document de valeur (2a) à vérifier, et
- le deuxième paramètre d'étalonnage (Vh) est prévu pour rectifier un signal magnétique (S) du capteur magnétique que le capteur magnétique, lors de l'examen d'un document de valeur, détecte d'une zone magnétique magnétiquement dure (H) du document de valeur (2a) à vérifier, et cependant
- que le capteur magnétique est conçu pour rectifier soit avec un des premiers paramètres d'étalonnage (Vw), soit avec un des deuxièmes paramètres d'étalonnage (Vh) un signal magnétique (S) du capteur magnétique que ce dernier détecte d'un document de valeur à vérifier, cependant que le capteur magnétique est conçu pour rectifier avec un des premiers paramètres d'étalonnage (Vw) un signal magnétique détecté d'une zone magnétique magnétiquement douce du document de valeur à vérifier, et pour rectifier avec un des deuxièmes paramètres d'étalonnage (Vh) un signal magnétique détecté d'une zone magnétique magnétiquement dure du document de valeur à vérifier, et
- le capteur magnétique comporte une mémoire de données (5) dans laquelle le au moins un premier paramètre d'étalonnage (Vw) et le au moins un deuxième paramètre d'étalonnage (Vh) du capteur magnétique sont stockés, cependant que, dans la mémoire de données (5), des informations sont contenues, lesquelles déterminent lequel des signaux magnétiques (S) que le capteur magnétique détecte d'un document de valeur sont à rectifier avec le premier paramètre d'étalonnage (Vw), et lequel des signaux magnétiques (S) que le capteur magnétique détecte d'un document de valeur sont à rectifier avec le deuxième paramètre d'étalonnage (Vh).

2. Capteur magnétique selon la revendication 1, **caractérisé en ce que** le capteur magnétique est conçu pour rectifier le signal magnétique détecté d'un document de valeur (2a) en fonction de la position (x, y) sur le document de valeur à laquelle le capteur magnétique détecte le signal magnétique (S), et/ou en fonction du type de document de valeur (a, b) du document de valeur à vérifier, au choix avec le premier paramètre d'étalonnage (Vw) ou avec le deuxième paramètre d'étalonnage (Vh).

3. Capteur magnétique selon une des revendications précédentes, **caractérisé en ce que** le capteur magnétique comporte plusieurs pistes de mesure (L1-L10) par lesquelles le capteur magnétique peut détecter un signal magnétique (S) à plusieurs positions (y) transversalement à la direction de transport (T) du document de valeur, et que le capteur magnétique, par piste de mesure (L1-L10), comporte respectivement tant un premier paramètre d'étalonnage (Vw) qu'un deuxième paramètre d'étalonnage (Vh) indépendant du premier paramètre d'étalonnage de la piste respective de mesure (L1-L10).

4. Capteur magnétique selon une des revendications précédentes, **caractérisé en ce que** le capteur magnétique (10) comporte un équipement d'évaluation (4) par lequel les signaux magnétique (S) détectés du capteur magnétique peuvent être traités et évalués au moyen d'un logiciel d'évaluation (6), cependant que le logiciel d'évaluation (6) est conçu pour, en fonction de si le signal magnétique (S) est détecté d'une zone magnétique magnétiquement douce (W) d'un document de valeur ou d'une zone magnétique magnétiquement dure (H) d'un document de valeur, rectifier soit sur la base du premier (Vw), soit sur la base du deuxième paramètre d'étalonnage (Vh) le signal magnétique (S) respectif.

5. Capteur magnétique selon une des revendications précédentes, **caractérisé en ce que** le capteur magnétique comporte un amplificateur électronique (12) configurable pour l'amplification des signaux magnétiques détectés (S) configuré pour, lors de l'examen d'un document de valeur, en fonction de si le signal magnétique (S) est détecté d'une zone magnétique magnétiquement douce (W) d'un document de valeur ou d'une zone magnétique magnétiquement dure (H) d'un document de valeur, régler la hauteur de son amplification soit sur la base du premier paramètre d'étalonnage (Vw), soit sur la base du deuxième paramètre d'étalonnage (Vh).

6. Capteur magnétique selon une des revendications précédentes, **caractérisé en ce que** le capteur magnétique comporte au moins un élément magnéto-sensible (11) configurable dont la sensibilité est configurable, et que, lors de l'examen d'un document de valeur, la sensibilité du au moins un élément magnéto-sensible (11) est réglé soit sur la base du premier (Vw), soit sur la base du deuxième paramètre d'étalonnage (Vh) en fonction de si le signal magnétique) est détecté d'une zone magnétique magnétiquement douce (W) d'un document de valeur ou d'une zone magnétique magnétiquement dure (H) d'un document de valeur.

7. Capteur magnétique selon une des revendications précédentes, **caractérisé en ce que** le capteur magnétique (10) comporte un mode d'étalonnage dans lequel le capteur magnétique peut détecter au moins une première et au moins une deuxième valeur de mesure d'étalonnage (Kw, Kh) d'un moyen d'étalonnage (1) et traiter subséquemment les valeurs de mesure d'étalonnage détectées, afin de vérifier la fonction du capteur magnétique (10) à l'aide de la première et deuxième valeur de mesure d'étalonnage détectée (Kw, Kh), cependant que, après la vérification de la fonction du capteur magnétique (10), en fonction du résultat de la vérification, le cas échéant un ajustement du capteur magnétique (10) est effectué, dans lequel le premier paramètre d'étalonnage (Vw) est déterminé à l'aide de la première valeur de mesure d'étalonnage détectée (Kw) et/ou le deuxième paramètre d'étalonnage (Vh) est déterminé à l'aide de la deuxième valeur de mesure d'étalonnage détectée (Kh), cependant que le capteur magnétique (10) est en particulier conçu pour exécuter en mode d'étalonnage le procédé d'étalonnage selon une des revendications de 9 à 12.

8. Dispositif de traitement de document de valeur doté d'un capteur magnétique (10) selon une des revendications de 1 à 7.

9. Procédé d'étalonnage d'un capteur magnétique (10) configuré pour l'examen de documents de valeur transportés pour l'examen le long d'une direction de transport (T) en passant par le capteur magnétique (10), cependant que le capteur magnétique
- comporte au moins un premier paramètre d'étalonnage (Vw) prévu pour rectifier un signal magnétique (S) du capteur magnétique que le capteur magnétique, lors de l'examen d'un document de valeur, détecte d'une zone magnétique magnétiquement douce (W) du document de valeur (2a) à vérifier, et
- comporte au moins un deuxième paramètre d'étalonnage (Vh), indépendant du/des premier(s) paramètre(s) d'étalonnage, prévu pour rectifier un signal magnétique (S) du capteur magnétique que le capteur magnétique, lors de l'examen d'un document de valeur, détecte d'une zone magnétique magnétiquement dure (H) du document de valeur (2a) à vérifier, et
- est conçu pour rectifier soit avec un des premiers paramètres d'étalonnage (Vw), soit avec un des deuxièmes paramètres d'étalonnage (Vh) un signal magnétique (S) du capteur magnétique que ce dernier détecte d'un document de valeur à vérifier, cependant que le capteur magnétique est conçu pour rectifier avec un des premiers paramètres d'étalonnage (Vw) un signal magnétique détecté d'une zone magnétique magnétiquement douce du document de valeur, et pour rectifier avec un des deuxièmes paramètres d'étalonnage (Vh) un signal magnétique détecté d'une zone magnétique magnétiquement dure du document de valeur,
- comporte une mémoire de données (5) dans laquelle le au moins un premier paramètre d'étalonnage (Vw) et le au moins un deuxième paramètre d'étalonnage (Vh) du capteur magnétique sont stockés, cependant que, dans la mémoire de données (5), des informations sont contenues, lesquelles déterminent lequel des signaux magnétiques (S) que le capteur magnétique détecte d'un document de valeur sont à rectifier avec le premier paramètre d'étalonnage (Vw), et lequel des signaux magnétiques (S) que le capteur magnétique détecte d'un document de valeur sont à rectifier avec le deuxième paramètre d'étalonnage (Vh), cependant que, lors de l'étalonnage du capteur magnétique,
- le capteur magnétique (10) détecte au moins une première valeur de mesure d'étalonnage d'une zone magnétique magnétiquement douce (w) existante dans/ sur un moyen d'étalonnage (1) transporté le long d'une direction de transport (T) en passant par le capteur magnétique (10) pour l'étalonnage du capteur magnétique, et/ou
- le capteur magnétique (10) détecte au moins une deuxième valeur de mesure d'étalonnage (Kh) d'une zone magnétique magnétiquement dure (h) existante dans/sur un moyen d'étalonnage (1) transporté le long d'une direction de transport (T) en passant par le capteur magnétique (10) pour l'étalonnage du capteur magnétique, et
- la première et/ou deuxième valeur de mesure d'étalonnage détectée (Kw, Kh) sont traitées subséquemment afin de vérifier la fonction du capteur magnétique (10) à l'aide de la première et deuxième valeur de mesure d'étalonnage détectée (Kw, Kh), cependant que, après la vérification de la fonction du capteur magnétique (10), en fonction du résultat de la vérification, le cas échéant un ajustement du capteur magnétique (10) est effectué, dans lequel le premier paramètre d'étalonnage (Vw) est déterminé à l'aide de la première valeur de mesure d'étalonnage détectée (Kw) et/ou le deuxième paramètre d'étalonnage (Vh) est déterminé à l'aide de la deuxième valeur de mesure d'étalonnage détectée (Kh).

10. Procédé selon la revendication 9, **caractérisé en ce que**, lors de la vérification de la fonction du capteur magnétique (10), il est vérifié si la première valeur de mesure d'étalonnage détectée (Kw) se situe à l'intérieur d'une plage d'acceptation autour d'une première valeur prescrite (Kw0), et si la deuxième valeur de mesure d'étalonnage détectée (Kh) se situe à l'intérieur d'une plage d'acceptation autour d'une deuxième valeur prescrite (Kh0), et en particulier qu'un ajustement du capteur magnétique (10) n'est effectué que si la première et/ou le deuxième valeur de mesure d'étalonnage détectée (Kw, Kh) se situe à l'extérieur de la plage respective d'acceptation autour de la valeur prescrite respective (Kw0, Kh0).

11. Procédé selon selon une ou plusieurs des revendications de 9 à 10, **caractérisé en ce que**, après la vérification de la fonction du capteur magnétique (10), en option, un ajustement du capteur magnétique est effectué si un opérateur auquel le résultat de la vérification est communiqué déclenche l'ajustement.

12. Procédé selon une ou plusieurs des revendications de 9 à 11, **caractérisé en ce que**
- le premier paramètre d'étalonnage (Vw) reste inchangé si la vérification de la fonction du capteur magnétique révèle que la première valeur de mesure d'étalonnage (Kw) détectée se situe à l'intérieur de la plage d'acceptation, et, si la vérification révèle que la première valeur de mesure d'étalonnage détectée (Kw) se situe à l'extérieur de la plage d'acceptation, que le premier paramètre d'étalonnage (Vw) est à nouveau déterminé sur la base de la première valeur de mesure d'étalonnage (Kw) détectée et que le jusque-là premier paramètre d'étalonnage est remplacé par celui qui est nouvellement déterminé, et
- le deuxième paramètre d'étalonnage (Vh) reste inchangé si la vérification de la fonction du capteur magnétique révèle que la deuxième valeur de mesure d'étalonnage (Kh) détectée se situe à l'intérieur de la plage d'acceptation, et, si la vérification révèle que la deuxième valeur de mesure d'étalonnage (Kh) détectée se situe à l'extérieur de la plage d'acceptation, qu'un deuxième paramètre d'étalonnage (Vh) est à nouveau déterminé sur la base de la deuxième valeur de mesure d'étalonnage (Kh) détectée et que le jusque-là deuxième paramètre d'étalonnage est remplacé par celui qui est nouvellement déterminé.

13. Procédé d'examen d'un document de valeur (2a) par un capteur magnétique (10) conçu pour l'examen de documents de valeur transportés pour l'examen le long d'une direction de transport (T) en passant par le capteur magnétique (10), cependant que le capteur magnétique
- comporte au moins un premier paramètre d'étalonnage (Vw) prévu pour rectifier un signal magnétique (S) du capteur magnétique que le capteur magnétique, lors de l'examen d'un document de valeur, détecte d'une zone magnétique magnétiquement douce (W) du document de valeur (2a) à vérifier, et
- comporte au moins un deuxième paramètre d'étalonnage (Vh), indépendant du/des premier(s) paramètre(s) d'étalonnage, prévu pour rectifier un signal magnétique (S) du capteur magnétique que le capteur magnétique, lors de l'examen d'un document de valeur, détecte d'une zone magnétique magnétiquement dure (H) du document de valeur (2a) à vérifier, et
- est conçu pour rectifier soit avec un des premiers paramètres d'étalonnage (Vw), soit avec un des deuxièmes paramètres d'étalonnage (Vh) un signal magnétique (S) du capteur magnétique que ce dernier détecte d'un document de valeur à vérifier, cependant que le capteur magnétique est conçu pour rectifier avec un des premiers paramètres d'étalonnage (Vw) un signal magnétique détecté d'une zone magnétique magnétiquement douce du document de valeur, et pour rectifier avec un des deuxièmes paramètres d'étalonnage (Vh) un signal magnétique détecté d'une zone magnétique magnétiquement dure du document de valeur, et
- comporte une mémoire de données (5) dans laquelle le au moins un premier paramètre d'étalonnage (Vw) et le au moins un deuxième paramètre d'étalonnage (Vh) du capteur magnétique sont stockés, cependant que, dans la mémoire de données (5), des informations sont contenues, lesquelles déterminent lequel des signaux magnétiques (S) que le capteur magnétique détecte d'un document de valeur sont à rectifier avec le premier paramètre d'étalonnage (Vw), et lequel des signaux magnétiques (S) que le capteur magnétique détecte d'un document de valeur sont à rectifier avec le deuxième paramètre d'étalonnage (Vh),
cependant que, pour l'examen d'un document de valeur (2a) comportant la au moins une zone magnétique magnétiquement douce (W) et/ou au moins une zone magnétique magnétiquement dure (H), les étapes suivantes sont effectuées :
- transport du document de valeur (2a) le long de la direction de transport (T) en passant par le capteur magnétique (10), cependant que le capteur magnétique (10) détecte des signaux magnétiques (S) de la zone magnétique magnétiquement douce (W) du document de valeur et/ou cependant que le capteur magnétique (10) détecte des signaux magnétiques (S) de la zone magnétique magnétiquement dure (H) du document de valeur, et
- rectification des signaux magnétiques (S) détectés de la zone magnétique magnétiquement douce (W) à l'aide du premier paramètre d'étalonnage (Vw) afin de compenser des erreurs de mesure du capteur magnétique dont sont entachés les signaux magnétiques (S) que le capteur magnétique détecte de la zone magnétique magnétiquement douce (W) du document de valeur, et utilisation du signal magnétique (RW) de la zone magnétique magnétiquement douce (W), rectifié à l'aide du premier paramètre d'étalonnage (Vw), pour l'examen du document de valeur (2a),
et/ ou
rectification des signaux magnétiques (S) détectés de la zone magnétique magnétiquement dure (H) à l'aide du deuxième paramètre d'étalonnage (Vh) afin de compenser des erreurs de mesure du capteur magnétique dont sont entachés les signaux magnétiques (S) que le capteur magnétique détecte de la zone magnétique magnétiquement dure (H) du document de valeur, et utilisation du signal magnétique (RH) de la zone magnétique magnétiquement dure (H), rectifié à l'aide du deuxième paramètre d'étalonnage (Vh), pour l'examen du document de valeur (2a).
